# EUROPEAN PATENT APPLICATION

(11) **EP 2 144 302 A2**
(43) Date of publication of application: **13.01.2010**
(21) Application number: 09165062.2
(22) Date of filing: 09.07.2009
(51) Int. Cl.: H01L 31/048

(54) **Photoelectric conversion device and manufacturing method of photoelectric conversion device**

(30) Priority: 10.07.2008 JP 2008180808
(71) Applicant: Semiconductor Energy Laboratory Co, Ltd., Atsugi-shi, Kanagawa-ken 243-0036 (JP)
(72) Inventor: Oikawa, Yoshiaki, Kanagawa-ken 243-0036 (JP); Eguchi, Shingo, Kanagawa-ken 243-0036 (JP); Mashiama, Mitsuo, Kanagawa-ken 243-0036 (JP); Kataniwa, Masatoshi, Kanagawa-ken 243-0036 (JP); SHoji, Hironobu, Kanagawa-ken 243-0036 (JP); Nakada, Masataka, Kanagawa-ken 243-0036 (JP)
(74) Representative: Grünecker, Kinkeldey, Stockmair & Schwanhäusser Anwaltssozietät

(57) **Abstract**

The purpose of the invention is to provide a highly reliable photoelectric conversion device having flexibility and resistance to external stress. In the photoelectric conversion device, following are included: a first sealing layer and a second sealing layer that are provided to face each other; and a photoelectric conversion element group which is provided by being interposed between the first sealing layer and second sealing layer that are provided to face each other. The first sealing layer includes a first structure body in which a first fibrous body is impregnated with a first organic resin, the second sealing layer includes a second structure body in which a second fibrous body is impregnated with a second organic resin, and a periphery of the photoelectric conversion element group includes a region where the first sealing layer and second sealing layer that are provided to face each other are attached to each other.

## Description

### BACKGROUND OF THE INVENTION

### 1. Field of the Invention

The present invention relates to a photoelectric conversion device and a manufacturing method of a photoelectric conversion device.

### 2. Description of the Related Art

While progress of global warming has been more serious and measures on environment issues have been urgent, the market for photoelectric conversion devices typified by solar cells has expanded. Since solar light as an energy source of a photoelectric conversion device is inexhaustible and there is a possibility to contribute to reduction of carbon-dioxide emissions as compared to other energy sources, the photoelectric conversion device has attracted attention as a clean power generation means of the next generation.

Photoelectric conversion devices of various kinds have already been developed, and, among them, a thin-film photoelectric conversion device utilizing an organic semiconductor or a non-single-crystal semiconductor typified by amorphous silicon can be manufactured at lower a process temperature. Thus, development and practical use of a flexible photoelectric conversion device which is manufactured over a flexible substrate such as a plastic substrate has been proceeding (for example, see Reference 1). The thin-film photoelectric conversion device is easy for achieving thinning, weight saving, increase in area, save of resources, and the like, and further excellent in workability and productivity if the thin-film photoelectric conversion device can have flexibility.

[Reference 1] Japanese Published Patent Application No. 2003-60214

Photoelectric conversion devices in which solar light is utilized as an energy source are provided outdoors for use in many cases. For example, since the photoelectric conversion device is attached to a roof, an outer wall, or the like of a building, reliability such as high weather resistance or durability is required. In addition, in order to distribute the photoelectric conversion device in the market, reliability and high mechanical strength as a product are required. Further, in order to improve a diffusion rate in general, workability such as easiness to be provided and design are also necessary in addition to reliability as a product. In order to obtain a highly reliable photoelectric conversion device, it is important to have the physical resistance to force such as pressing force (hereinafter also referred to as external stress) which is externally applied after the photoelectric conversion device is distributed as a product. In addition, since there is also the case where the photoelectric conversion device is provided with a curved shape at the time of working, resistance to bending and twisting is also necessary. Further, in order to improve the yield of products at the time of the manufacture, it is also necessary to ensure adequate mechanical resistance in the manufacturing process and try to suppress incidence of defects which is due to shortage of strength.

### SUMMARY OF THE INVENTION

In view of the foregoing problems, according to one embodiment of the present invention, it is an object to provide a highly reliable photoelectric conversion device having flexibility and resistance to external stress. In addition, it is another object to provide a photoelectric conversion device having high mechanical strength as a product. Moreover, it is another object to prevent quality defects such as defective shapes and defective characteristics due to external stress in the manufacturing process, and to manufacture photoelectric conversion devices with high yield. Further, it is another object to manufacture flexible photoelectric conversion devices with high productivity.

According to one embodiment of the present invention, a photoelectric conversion device includes a photoelectric conversion element group which is interposed between a pair of sealing layers that is provided to face each other. In addition, a structure body in which a fibrous body is impregnated with an organic resin is used as the sealing layer. Moreover, in a peripheral portion of the photoelectric conversion element group, the photoelectric conversion device includes a region in which the pair of sealing layers is directly attached to each other.

According to another embodiment of the present invention, a photoelectric conversion device includes a first sealing layer and a second sealing layer that face each other, and a photoelectric conversion element group which is provided by being interposed between the first sealing layer and second sealing layer that are provided to face each other. In the photoelectric conversion device, the first sealing layer has a first structure body in which a first fibrous body is impregnated with a first organic resin, the second sealing layer has a second structure body in which a second fibrous body is impregnated with a second organic resin, and a periphery of the photoelectric conversion element group which is provided by being interposed between the first sealing layer and the second sealing layer that face each other has a region where the first sealing layer and the second sealing layer that are provided to face each other are attached to each other.

According to another embodiment of the present invention, a photoelectric conversion device includes a first sealing layer and a second sealing layer that are provided to face each other, and a photoelectric conversion element group which is provided by being interposed between the first sealing layer and second sealing layer that face each other. In the photoelectric conversion device, the first sealing layer has a first structure body in which a first fibrous body is impregnated with a first organic resin, and a first protective layer having a modulus of elasticity lower than that of the first structure body on a side of the first structure body, which is opposed to a side in contact with the second sealing layer. The second sealing layer has a second structure body in which a second fibrous body is impregnated with a second organic resin, and a second protective layer having a modulus of elasticity lower than that of the second structure body on a side of the second structure body, which is opposed to a side in contact with the first sealing layer. A periphery of the photoelectric conversion element group which is provided by being interposed between the first sealing layer and the second sealing layer that face each other has a region where the first sealing layer and the second sealing layer that are provided to face each other are attached to each other.

It is preferable that the first protective layer and the second protective layer contain any one of an aramid resin, a polyethylene naphthalate resin, a polyether sulfone resin, a polyphenylene sulfide resin, and a polyimide resin.

In any of the above structures, at least one of the surface of the first sealing layer and the surface of the second sealing layer can be provided with a conductive layer. In addition, an inorganic insulating layer can be provided at least between the photoelectric conversion element group and the first structure body and between the photoelectric conversion element group and the second structure body.

In addition, the first sealing layer and the second sealing layer preferably have symmetrical layer structures with respect to the photoelectric conversion element group.

In any of the above structures, the first organic resin and the second organic resin preferably contain a thermosetting resin or a thermoplastic resin. In addition, the first fibrous body and the second fibrous body are preferably poly(vinyl alcohol) fiber, polyester fiber, polyamide fiber, polyethylene fiber, aramid fiber, polyparaphenylenebenzobisoxazole fiber, glass fiber, or carbon fiber.

In addition, the photoelectric conversion element group preferably includes a plurality of photoelectric conversion elements which are electrically connected in series.

The "photoelectric conversion element" in this specification refers to a minimum unit that can generate a photoelectric effect and generate power. In addition, the "photoelectric conversion device" in this specification refers to a power generating device provided with at least one photoelectric conversion element, and a module in which a plurality of photoelectric conversion elements are integrated is also included in its category. Moreover, the "photoelectric conversion element group" in this specification refers to an element region in which a photoelectric effect is generated and power is generated, which includes at least one photoelectric conversion element.

In addition, the "external stress" in this specification includes all the kinds of stress that may adversely affect photoelectric conversion devices, for example, movement of deformation such as bending, mechanical stress such as locally applied pressure (pressing force), electrical stress such as static electricity, physical stress such as wind or dust, and the like. Further, the external stress includes the stress given when the photoelectric conversion device is distributed, provided, or used; or the stress given during the manufacturing process.

According to one embodiment of the present invention, resistance to the external stress of a photoelectric conversion device can be increased. In addition, a photoelectric conversion device having high mechanical strength as a product can be provided. Moreover, a photoelectric conversion device having high reliability as well as flexibility can be provided.

### BRIEF DESCRIPTION OF THE DRAWINGS

FIG. 1A is a plan view illustrating a photoelectric conversion device according to one embodiment of the present invention, and FIGS. 1B and 1C are cross-sectional views thereof;
FIG. 2 is a plan view illustrating a fibrous body which forms a structure body;
FIGS. 3A to 3C are cross-sectional views illustrating a manufacturing method of a photoelectric conversion device according to one embodiment of the present invention;
FIGS. 4A to 4C are cross-sectional views illustrating the manufacturing method of the photoelectric conversion device according to one embodiment of the present invention;
FIGS. 5A and 5B are cross-sectional views illustrating the manufacturing method of the photoelectric conversion device according to one embodiment of the present invention;
FIGS. 6A and 6B are plan views illustrating the manufacturing method of the photoelectric conversion device according to one embodiment of the present invention;
FIGS. 7A and 7B are plan views illustrating the manufacturing method of the photoelectric conversion device according to one embodiment of the present invention;
FIG. 8 is a cross-sectional view illustrating a photoelectric conversion device according to one embodiment of the present invention;
FIGS. 9A and 9B are cross-sectional views illustrating a manufacturing method of a photoelectric conversion device according to one embodiment of the present invention;
FIG. 10 is a cross-sectional view illustrating a photoelectric conversion device according to one embodiment of the present invention;
FIGS. 11A and 11B are cross-sectional views illustrating photoelectric conversion devices according to one embodiment of the present invention;
FIGS. 12A to 12D are cross-sectional views illustrating photoelectric conversion devices according to one embodiment of the present invention;
FIGS. 13A1 and 13A2 and FIGS. 13B1 and 13B2 are views illustrating a manufacturing method of a photoelectric conversion device according to one embodiment of the present invention, where FIGS. 13A1 and 13B1 are cross-sectional views thereof and FIGS. 13A2 and 13B2 are plan views thereof;
FIG. 14 is a cross-sectional view of a photoelectric conversion device according to one embodiment of the present invention;
FIG. 15 is a view illustrating a manufacturing method of a photoelectric conversion device according to one embodiment of the present invention; and
FIG. 16 is a cross-sectional view illustrating another photoelectric conversion device according to one embodiment of the present invention.

### DETAILED DESCRIPTION OF THE INVENTION

Embodiments of the present invention will be described with reference to the accompanying drawings. However, the present invention is not limited to the description below, and it is easily understood by those skilled in the art that modes and details thereof can be modified in various ways without departing from the spirit and the scope of the present invention. Therefore, the present invention should not be interpreted as being limited to the description of the embodiments. Note that the same portions or portions having the same functions in the structure of the present invention described below are denoted by the same reference numerals and repetitive description thereof will be omitted.

### [Embodiment 1]

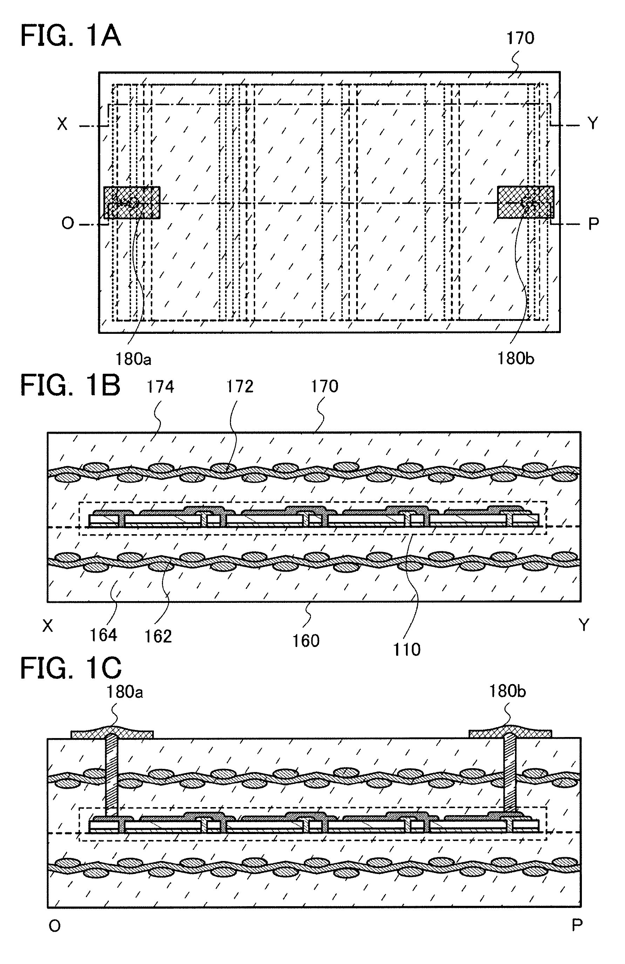

Schematic views of a photoelectric conversion device according to one embodiment of the present invention are illustrated in FIGS. 1A to 1C. FIG. 1A illustrates a plan schematic view, FIG. 1B illustrates a cross-sectional schematic view taken along line X-Y in FIG. 1A, and FIG. 1C illustrates a cross-sectional schematic view taken along line O-P in FIG. 1A.

The photoelectric conversion device according to one embodiment of the present invention is provided with a first sealing layer and a second sealing layer that are provided to face each other; and an element region including a photoelectric conversion element group which is interposed between the first sealing layer and the second sealing layer that face each other.

In this embodiment, a structure body in which a first fibrous body is impregnated with a first organic resin is used as the first sealing layer. A structure body in which a second fibrous body is impregnated with a second organic resin is used as the second sealing layer. Specifically, a first structure body 160 in which a first fibrous body 162 is impregnated with a first organic resin 164 is used as the first sealing layer. A second structure body 170 in which a second fibrous body 172 is impregnated with a second organic resin 174 is used as the second sealing layer.

A photoelectric conversion element group 110 which forms the element region includes at least one photoelectric conversion element. In addition, in order to extract generated power outside, an output terminal 180a and an output terminal 180b which are electrically connected to the photoelectric conversion element group 110 are provided.

The embodiment of the present invention has a structure in which a structure body in which a fibrous body is impregnated with an organic resin is used as a sealing layer, and an element region is sealed between a pair of sealing layers. Specifically, the photoelectric conversion device includes a photoelectric conversion element group which is interposed between the pair of sealing layers that is provided to face each other, and a region in which the pair of sealing layers is directly attached to each other in a peripheral portion of the photoelectric conversion element group. The structure body in which a fibrous body is impregnated with an organic resin has resistance to external stress and can function as an impact resistance layer. In addition, the structure body in which a fibrous body is impregnated with an organic resin functions as a sealing layer which can have flexibility. With the use of the structure body in which a fibrous body is impregnated with an organic resin, mechanical strength as a product can be enhanced without any loss of flexibility; thus, resistance to external stress can be increased. Further, resistance to the external stress in the manufacturing process can also be increased. Therefore, a highly reliable photoelectric conversion device can be provided.

In addition, adhesion of the sealing layers can be enhanced by having the region in which the pair of sealing layers is directly attached to each other in the peripheral portion of the photoelectric conversion element group. Preferably, the adhesion can be further enhanced in such a structure in which the peripheral portion of the photoelectric conversion element group is surrounded with the region in which the pair of sealing layers is directly attached to each other. Therefore, it is possible to prevent incidence of quality defects such as separation of the sealing caused during the manufacturing process or after the photoelectric conversion device is distributed as a product. In addition, the adhesion is enhanced, so that workability can be improved because resistance is increased even with respect to various transformations such as curvature. Further, the element region can be prevented from being directly exposed to wind, dust, or the like by the sealing; thus, weather resistance can be enhanced.

In this embodiment, the photoelectric conversion element group 110 is sealed using the first structure body 160 in which the first fibrous body is impregnated with the first organic resin and the second structure body 170 in which the second fibrous body is impregnated with the second organic resin, as the pair of sealing layers that is provided to face each other. In addition, there is the region in which the first structure body 160 and the second structure body 170 are directly attached to each other in the peripheral portion of the photoelectric conversion element group 110. The peripheries (the upper, lower, and side surfaces) of the photoelectric conversion element group 110 are covered with the first structure body 160 and the second structure body 170.

As described above, the photoelectric conversion element group 110 is sealed with the first structure body 160 and the second structure body 170 which are each the structure body in which a fibrous body is impregnated with an organic resin, so that a photoelectric conversion device having increased resistance to external stress can be obtained without any loss of flexibility.

Next, specific structures of the photoelectric conversion device which is illustrated in FIGS. 1A to 1C, materials that can be applied to each structure, and the like are described in detail.

First, in this embodiment, the first structure body 160 used for the first sealing layer and the second structure body 170 used for the second sealing layer are described. The first structure body 160 is the structure body in which the first fibrous body 162 is impregnated with the first organic resin 164. The second structure body 170 is the structure body in which the second fibrous body 172 is impregnated with the second organic resin 174.

The first fibrous body 162 and the second fibrous body 172 are each a woven or nonwoven fabric using high-strength fibers of an organic compound or an inorganic compound and provided so as to overlap partially with each other. The high-strength fiber is specifically a fiber with a high modulus of elasticity in tension or a fiber with a high Young's modulus. As typical examples of a high-strength fiber, poly(vinyl alcohol) fiber, polyester fiber, polyamide fiber, polyethylene fiber, aramid fiber, polyparaphenylenebenzobisoxazole fiber, glass fiber, carbon fiber, and the like can be given. As the glass fiber, glass fiber using E glass, S glass, D glass, Q glass, and the like can be given. Note that the first fibrous body 162 and the second fibrous body 172 may be formed with one kind of the above-described high-strength fibers or a plurality of the above-described high-strength fibers.

The first fibrous body 162 and the second fibrous body 172 are each a woven fabric which is woven using bundles of fibers (single yarns) (hereinafter the bundles of fibers are referred to as yarn bundles) for warp yarns and weft yarns. Alternatively, the first fibrous body 162 and the second fibrous body 172 may each be a nonwoven fabric obtained by stacking yarn bundles of plural kinds of fibers in a random manner or in one direction. In the case of a woven fabric, a plain-woven fabric, a twilled fabric, a satin-woven fabric, or the like can be used as appropriate.

The yarn bundle may have a circular shape or an elliptical shape in cross section. As the yarn bundle of fibers, a yarn bundle of fibers may be used, which has been subjected to fiber opening with a high-pressure water stream, high-frequency vibration using liquid as a medium, continuous ultrasonic vibration, pressing with a roll, or the like. A yarn bundle of fibers which is subjected to fabric opening has a large width, can reduce the number of single yarns in the thickness direction, and has an elliptical shape or a flat shape in its cross section. Further, by using a loosely twisted yarn as the yarn bundle of fibers, the yarn bundle is easily flattened and has an elliptical shape or a flat shape in cross section. Using a yarn bundle having an elliptical shape or a flat shape in cross section in this manner can reduce the thickness of the first fibrous body 162 and the second fibrous body 172. Accordingly, the thickness of the first structure body 160 and the second structure body 170 can be reduced, and thus a thin photoelectric conversion device can be manufactured.

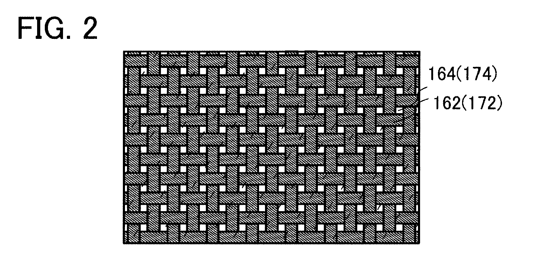

For example, as the first fibrous body 162 and the second fibrous body 172, woven fabrics which are woven using fiber yarn bundles for warp yarns and weft yarns as illustrated in a plan view of FIG. 2 can be applied.

As illustrated in FIG. 2, the first fibrous body 162 (or the second fibrous body 172) is woven using warp yarns spaced at regular intervals and weft yarns spaced at regular intervals. Such a fibrous body which is woven using the warp yarns and the weft yarns has regions without the warp yarns and the weft yarns. In such a first fibrous body 162 (or a second fibrous body 172), the fibrous body is further impregnated with the first organic resin 164 (or the second organic resin 174), whereby adhesion between an element (the photoelectric conversion element group 110) and the first fibrous body 162 (or the second fibrous body 172) can be increased.

Further, in the first fibrous body 162 and the second fibrous body 172, density of the warp yarns and the weft yarns may be high and a proportion of the regions without the warp yarns and the weft yarns may be low.

Note that in FIG. 2, the first fibrous body 162 (or the second fibrous body 172) is illustrated as a woven fabric which is plain-woven using a yarn bundle having an elliptical shape in cross section.

A thermosetting resin such as an epoxy resin, an unsaturated polyester resin, a polyimide resin, a bismaleimide-triazine resin, or a cyanate resin can be used for the first organic resin 164 and the second organic resin 174. Alternatively, a thermoplastic resin such as a polyphenylene oxide resin, a polyetherimide resin, or a fluorine resin can be used for the first organic resin 164 and the second organic resin 174. Further alternatively, a plurality of thermosetting resins or a plurality of thermoplastic resins may be used as the first organic resin 164 and the second organic resin 174. Furthermore, a mixture of the thermosetting resin and the thermoplastic resin may be used. When an organic resin which is any of the above thermoplastic resins or thermosetting resins is used, the fibrous bodies can be firmly fixed to an object (the photoelectric conversion element group 110 and the structure body that is provided to face) by a heat treatment. When an organic resin with which a fibrous body is impregnated is a thermosetting resin, the organic resin is cured by a heat treatment. In the case of a thermoplastic resin, the organic resin is plasticized by a heat treatment and is cured by cooling. The higher the glass transition temperature of the first organic resin 164 and the second organic resin 174 is, the harder the first organic resin 164 and the second organic resin 174 are destroyed by local pressure under a high-temperature environment, which is preferable.

In addition, highly-thermally conductive filler may be dispersed in the first organic resin 164 and the second organic resin 174, or the yarn bundle which is used as the fibrous body. As the highly-thermally conductive filler, aluminum nitride, boron nitride, silicon nitride, alumina, and the like can be given. As the highly-thermally conductive filler, metal particles of silver, copper, and the like can also be given. When the highly-thermally conductive filler is included in the organic resin or the yarn bundles, heat generated in the photoelectric conversion device can be easily released. Accordingly, a decrease in conversion efficiency due to a temperature rise of the photoelectric conversion device can be reduced.

A structure body in which a fibrous body is impregnated with an organic resin (in this embodiment, the first structure body in which the first fibrous body 162 is impregnated with the first organic resin 164 and the second structure body in which the second fibrous body 172 is impregnated with the second organic resin 174) is also referred to as a prepreg. A prepreg is specifically formed in a following manner: after a fibrous body is impregnated with a varnish in which a matrix resin is diluted with an organic solvent, drying is performed so that the organic solvent is volatilized and the matrix resin is semi-cured. The thickness of the structure body is preferably equal to or greater than 10 µm and equal to or less than 100 µm, preferably equal to or greater than 10 µm and equal to or less than 30 µm. When a structure body with such a thickness is used, a thin flexible photoelectric conversion device capable of being curved can be manufactured. For example, a prepreg after being completely cured with a modulus of elasticity of equal to or greater than 13 GPa and equal to or less than 15 GPa and a modulus of rupture of 140 MPa can be used for the structure body in which a fibrous body is impregnated with an organic resin.

Note that as the first structure body 160 and the second structure body 170, a plurality of structure bodies in each of which a fibrous body is impregnated with an organic resin may be stacked. In this case, the structure body may be formed by stacking a plurality of structure bodies in each of which a fibrous body with a single layer is impregnated with an organic resin. Alternatively, a structure body in which a stack of a plurality of fibrous bodies is impregnated with an organic resin may be used. In stacking a plurality of structure bodies in each of which a fibrous body of a single layer is impregnated with an organic resin, another layer may be interposed between the structure bodies.

Further, in order to enhance permeability of an organic resin into the inside of the yarn bundle of fibers, the fiber may be subjected to a surface treatment. For example, as the surface treatment for activating a surface of the fiber, corona discharge, plasma discharge, and the like can be given. Further, a surface treatment using a silane coupling agent or a titanate-coupling agent can be given.

The element region (the photoelectric conversion element group 110) which is interposed between the first structure body 160 and the second structure body 170 that are provided to face each other can be attached to the first structure body 160 and the second structure body 170 by a heat treatment and a pressure treatment.

Note that the same fiber or different fibers can be applied to the first fibrous body 162 and the second fibrous body 172. In addition, the same resin or different resins can be applied to the first organic resin 164 and the second organic resin 174. When the first structure body 160 in which the first fibrous body 162 is impregnated with the first organic resin 164 and the second structure body 170 in which the second fibrous body 172 is impregnated with the second organic resin 174 are structure bodies of the same fiber, difference in stress or the like is easily reduced. As a result, defects such as separation or warpage can be prevented.

Note that as illustrated in FIGS. 1A to 1C, in the first structure body 160 and the second structure body 170, the element region (the photoelectric conversion element group 110) is preferably disposed in the central portion (including the center and a periphery of the center). In addition, in a region where there is no element region (a peripheral portion of the element region), it is preferable to have a structure in which the element region is sealed with the first structure body 160 and the second structure body 170 in contact with each other. In addition, it is preferable that the sealing layers that are provided to face each other have a symmetrical structure with respect to the element region serving as a boundary. Specifically, the first structure body 160 and the second structure body 170 have a symmetrical structure, in which the photoelectric conversion element group 110 is preferably disposed at the center. In the symmetrical structure, it is preferable that the material and the thickness be the same. Here, the thickness refers to a minimum distance from a surface outside each of the structure bodies to a surface outside the photoelectric conversion element group 110. For example, the minimum distance from a surface outside the first structure body 160 to the surface outside the photoelectric conversion element group 110 is a thickness t1. In addition, the minimum distance from a surface outside the second structure body 170 to the surface outside the photoelectric conversion element group 110 is a thickness t2. In the photoelectric conversion device according to this embodiment, the thickness t1 and the thickness t2 are preferably close and more preferably equal. In addition, it is preferable that the materials of the first fibrous body 162 and the second fibrous body 172 be the same and that the materials of the first organic resin 164 and the second organic resin 174 be the same. Note that the structure bodies are not limited to uniform thickness. In addition, the thickness of the region in which the first structure body and the second structure body are attached to each other in the peripheral portion of the photoelectric conversion element group is not considered. With such a structure, the external stress applied to a photoelectric conversion device and a photoelectric conversion element can be made uniform. Alternatively, the external stress applied to a photoelectric conversion device and a photoelectric conversion element can be reduced. The above structure has a resistance characteristics on a transformation such as curvature, and thus defective characteristics and breakage of a photoelectric conversion device and a photoelectric conversion element can be prevented. Further, product workability can also be enhanced.

The photoelectric conversion element group 110 is formed with at least one photoelectric conversion element. Little power is generated with one photoelectric conversion element. Therefore, the photoelectric conversion element group 110 is preferably obtained by connecting a plurality of photoelectric conversion elements in series or in parallel so that desired power can be generated. The kind of photoelectric conversion element which can be applied to the embodiment of the present invention is not particularly limited. An inorganic photoelectric conversion element such as a photoelectric conversion element using a Group IV semiconductor and a photoelectric conversion element using a compound semiconductor (Group III-V, Group II-VI, Group I-III-VI, and the like); an organic photoelectric conversion element such as photoelectric conversion element using an organic semiconductor and a dye-sensitization photoelectric conversion element (a wet photoelectric conversion element); a hybrid photoelectric conversion element in which an inorganic-based material and an organic material-based are combined; and the like can be given. Typically, silicon photoelectric conversion elements such as amorphous silicon, microcrystalline silicon, polycrystalline silicon, and single crystal silicon can be given. Besides, a compound-semiconductor photoelectric conversion element using gallium arsenide, copper sulfide indium, or the like; an organic-semiconductor photoelectric conversion element using phthalocyanine or fullerene; and a dye-sensitization photoelectric conversion element using titanium oxide can be given. Moreover, as the photoelectric conversion element, a tandem structure or a stacked structure in which cells are stacked can also be applied.

Note that in the case where a structure body in which a fibrous body is impregnated with an organic resin functions as an element formation substrate, the structure body in which a fibrous body is impregnated with an organic resin which functions as the element formation substrate is used after being cured. Therefore, it is preferable to apply a non-single-crystal silicon photoelectric conversion element or an organic-semiconductor photoelectric conversion element which can be formed in a low temperature process of less than the upper temperature limit of the structure body in which a fibrous body is impregnated with an organic resin, which functions as the element formation substrate. Alternatively, it is preferable to apply a non-single-crystal silicon photoelectric conversion element or an organic-semiconductor photoelectric conversion element which can be formed in a low temperature process of less than the temperature at which the structure body in which a fibrous body is impregnated with an organic resin, which function as the element formation substrate, is plasticized. The non-single-crystal silicon photoelectric conversion element and the organic-semiconductor photoelectric conversion element are preferable in terms of excellent productivity because they can easily be formed over a large-sized substrate. Moreover, since the thickness for generating photoelectric conversion can be reduced, the non-single-crystal silicon photoelectric conversion element and the organic-semiconductor photoelectric conversion element are preferable in terms of thinning.

Note that the number of photoelectric conversion elements which form the photoelectric conversion element group 110, and the area and a connection method thereof may be determined at a designer's discretion.

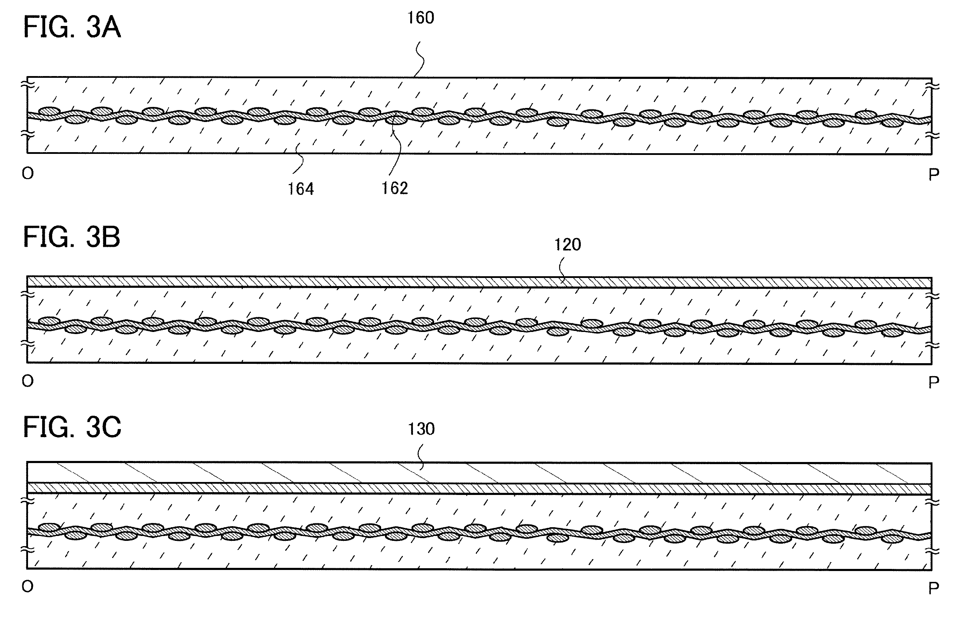

Next, examples of a manufacturing method of a photoelectric conversion device, which is one embodiment of the present invention, will be described with reference to FIGS. 3A to 3C, FIGS. 4A to 4C, FIGS. 5A and 5B, FIGS. 6A and 6B, and FIGS. 7A and 7B. Here, the descriptions are made using plan views and cross-sectional views.

As the first sealing layer, the first structure body 160 is prepared (see FIG. 3A).

In this embodiment, the first structure body 160 in which the first fibrous body 162 is impregnated with the first organic resin 164 is used as the first sealing layer. In this embodiment, the first structure body 160 in which the first fibrous body 162 is impregnated with the first organic resin 164 is used by being cured in advance. The first structure body 160 in which the first fibrous body 162 is impregnated with the first organic resin 164 is cured by a heat treatment or a heat treatment and a pressure treatment. In the case where the first organic resin 164 is a thermoplastic resin, an organic resin which is plasticized by a heat treatment is cured. Note that the cure degree of a structure body in which a fibrous body is impregnated with an organic resin can be adjusted by temperature, time, or the like of a heat treatment. In addition, the curing temperature, plasticization temperature, or the upper temperature limit after the curing can be adjusted with the material of the first organic resin 164 with which the first fibrous body 162 is impregnated. Here, the first structure body 160 is cured in advance until the first structure body 160 can function as an element formation substrate which forms the element region (the photoelectric conversion element group).

For example, a prepreg which is a structure body in which glass fiber that is a fibrous body is impregnated with a brominated epoxy resin that is an organic resin is cured by being subjected to a heat treatment at 190 °C for one hour, and the prepreg is used as the first structure body 160.

The first electrode 120 is formed over the first structure body 160 (see FIG. 3B).

When the first structure body 160 side is a light incidence plane, a light-transmitting oxide conductive material such as ITO, ZnO, SnO₂, or an ITO-ZnO alloy is formed by a sputtering method, an evaporation method, a printing method, or the like. The thickness of the light-transmitting oxide conductive material which serves as the first electrode 120 is 40 nm to 200 nm, preferably 50 nm to 100 nm, and the sheet resistance thereof may be about 20 Ω/square to 200 Ω/square.

In addition, the first electrode 120 can also be formed using a conductive composition containing a conductive macromolecule (also referred to as a conductive polymer). As the conductive macromolecule contained in the conductive composition, a so-called π-electron conjugated conductive macromolecule can be used. For example, polyaniline and/or a derivative thereof, polypyrrole and/or a derivative thereof, polythiophene and/or a derivative thereof, and a copolymer of two or more kinds of those materials can be given. In the case where a thin film which forms the first electrode 120 is formed using the conductive composition, it is preferable that the sheet resistance of the thin film which is formed with the conductive composition be equal to or less than 10000 Ω/square. In addition, the thin film preferably has a light transmittance of equal to or greater than 70 % with respect to light with a wavelength of 550 nm. Further, the resistance of the conductive macromolecule contained in the conductive composition is preferably equal to or less than 0.1 Ω·cm.

Note that the first electrode 120 can be formed using the above-described conductive macromolecule singly as the conductive composition. On the other hand, the first electrode 120 may be formed using the conductive composition whose property is adjusted with addition of an organic resin. In addition, the conductive composition may be doped with an acceptor dopant or a donor dopant to adjust electric conductivity of the conductive composition. By this doping effect, an oxidation-reduction potential of a conjugated electron of a conjugated conductive macromolecule contained in the conductive composition can be changed.

Further, the conductive composition may be dissolved in a solvent such as water or an organic solvent (e.g., an alcohol-based solvent, a ketone-based solvent, an ester-based solvent, a hydrocarbon-based solvent, an aromatic-based solvent, or the like) and a thin film which serves as the first electrode 120 can be formed by a wet process. Specifically, the first electrode 120 can be formed using the conductive composition by a wet process such as an application method, a coating method, a droplet discharge method (also referred to as an ink-jet method), or a printing method. The solvent may be dried with a heat treatment or the like under normal pressure or reduced pressure. In addition, in the case where the property of the above conductive composition is adjusted with addition of an organic resin, another heat treatment may be performed after the solvent is dried in the case where the added organic resin is a thermosetting resin. In the case where the added organic resin is a photocuring resin, a light irradiation treatment may be performed after the solvent is dried.

Alternatively, a composite light-transmitting conductive material formed by combining an organic compound and an inorganic compound can be used for the first electrode 120. Note that "composition" does not simply mean a state in which two materials are mixed, but also a state in which charges can be transported between two materials (or among three or more materials) by mixing the materials.

Specifically, as the above composite light-transmitting conductive material, it is preferable to use a composite material including a hole-transporting organic compound and a metal oxide which shows an electron accepting property with respect to the hole-transporting organic compound. In the composite light-transmitting conductive material, by combining the organic compound and the metal oxide, resistivity can be equal to or less than 1 × 10⁶ Ω·cm. The hole-transporting organic compound refers to a substance in which a hole transporting property is higher than an electron transporting property and preferably to a substance having a hole mobility of equal to or greater than 10⁻⁶ cm²/Vsec. Specifically, as the hole-transporting organic compound, various compounds such as an aromatic amine compound, a carbazole derivative, aromatic hydrocarbon, and a macromolecular compound (an oligomer, a dendrimer, a polymer, or the like) can be used. In addition, as the metal oxide, a transition metal oxide is preferable, which is preferably an oxide of a metal belonging to any of Groups IV to VIII in the periodic table. Specifically, it is preferable to use vanadium oxide, niobium oxide, tantalum oxide, chromium oxide, molybdenum oxide, tungsten oxide, manganese oxide, or rhenium oxide because of their high electron accepting properties. Above all, molybdenum oxide is particularly preferable because it is stable in the atmosphere, low in hygroscopicity, and is easy to be handled.

Note that a manufacturing method of the first electrode 120 using the above composite light-transmitting conductive material may be any, regardless of a wet process or a dry process. For example, the first electrode 120 using the composite light-transmitting conductive material can be formed by co-evaporation of the above organic compound and inorganic compound. Further, the first electrode 120 can also be formed in such a manner that a solution containing the above organic compound and metal alkoxide is applied and baked. The application of the organic compound and metal alkoxide can be performed using an ink-jet method, a spin coating method, or the like.

In the case where the first electrode 120 is formed using the composite light-transmitting conductive material, by selecting the kind of the organic compound contained in the composite light-transmitting conductive material, the first electrode 120 that does not have a peak of an absorption spectrum in a wavelength region of 450 nm to 800 nm can be formed. Thus, light can be transmitted efficiently in the first electrode 120 without being absorbing the light having a specific wavelength intensively; accordingly, light absorptance in a photoelectric conversion layer can be improved.

In addition, a thin film which is formed using the above composite light-transmitting conductive material has high resistance to curvature such as bending. Thus, the thin film can be preferably used as an electrode of a flexible photoelectric conversion device according to one embodiment of the present invention.

In addition, as the first electrode 120, a metal material such as aluminum, silver, gold, titanium, tungsten, platinum, nickel, molybdenum, or an alloy containing any of these metals can also be used. Even in the case where the metal material is used for the first electrode 120, desired transmittance can be obtained by having a thin film with a thickness of about 1 nm to 20 nm. Therefore, light can also enter the photoelectric conversion layer from the first electrode 120 side by having the above structure of the first electrode 120.

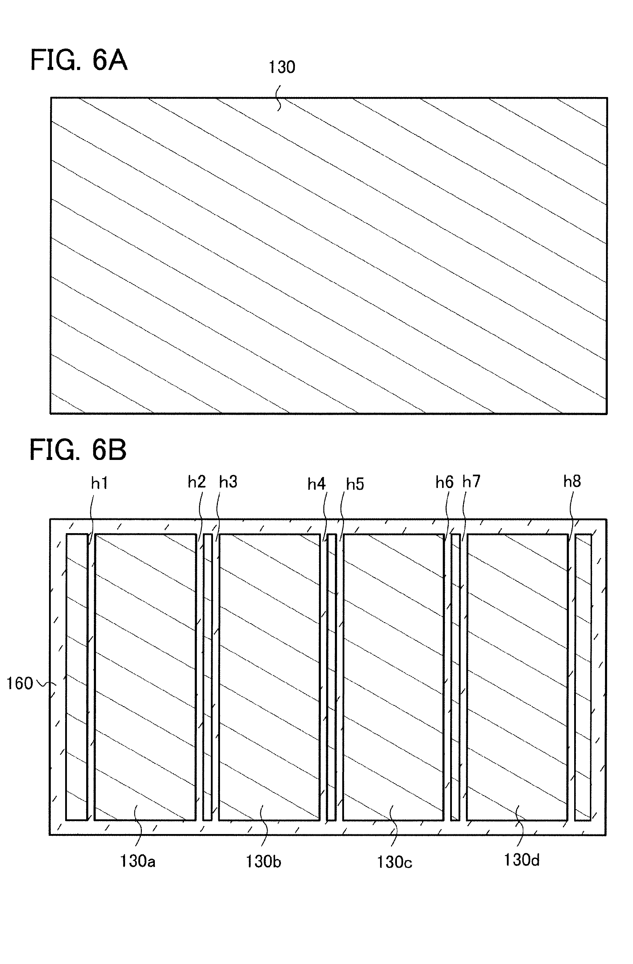

Next, a photoelectric conversion layer 130 is formed over the first electrode 120 (see FIG. 3C and FIG. 6A).

The photoelectric conversion layer 130 is a region conducting photoelectric conversion. In addition, here, the "photoelectric conversion layer" includes a layer by which a photoelectric (internal photoelectric) effect is achieved and moreover a layer (here an impurity semiconductor layer) bonded for forming an internal electric field or a semiconductor junction.

As the photoelectric conversion layer 130, a Group IV semiconductor typified by silicon, an inorganic compound semiconductor typified by gallium arsenide (a Group III-V semiconductor, a Group II-VI semiconductor, a Group I-III-VI semiconductor, and the like), and an organic semiconductor such as fullerene or copper phthalocyanine can be used. In addition, in order to perform photoelectric conversion efficiently, an element structure of the semiconductor has a photoelectric conversion layer in which a junction of a different conductivity type (a pn junction, a pin junction, a pp-in junction, a pin-n junction, a pp-in-n junction, or the like) is formed.

For example, as the photoelectric conversion layer 130, a pin-junction non-single-crystal semiconductor is formed. Specifically, a pin-junction amorphous semiconductor (typically, amorphous silicon) or a pin-junction microcrystalline semiconductor (typically, microcrystalline silicon) can be formed. In addition, it is also possible to form a p-type impurity semiconductor layer or an n-type impurity semiconductor layer with a microcrystalline semiconductor (microcrystalline silicon) and to form an i-type semiconductor layer with an amorphous semiconductor (amorphous silicon). The amorphous semiconductor or the microcrystalline semiconductor is formed by a chemical vapor deposition (CVD) method typified by a plasma CVD method. Specifically, the amorphous semiconductor or the microcrystalline semiconductor can be formed by a plasma CVD method using a semiconductor material gas such as silicon hydride typified by silane or disilane; silicon chloride such as SiH₂Cl₂, SiHCl₃, or SiCl₄; or silicon fluoride such as SiF₄. A s a reactive gas, the semiconductor material gas diluted with a dilution gas may be used. A typical example of the dilution gas is hydrogen, and besides one or more kinds of rare gas element selected from helium, argon, krypton, and neon can be given. In addition, the dilution gas can be used in combination with plural kinds (for example, hydrogen and argon). The amorphous semiconductor may be formed using a reactive gas capable of generating an amorphous semiconductor, and the microcrystalline semiconductor may be formed using a reactive gas capable of generating a microcrystalline semiconductor. For example, the microcrystalline semiconductor may be formed using a reactive gas in which the flow rate ratio of the dilution gas (typically, hydrogen) with respect to the semiconductor material gas (typically, silane) is equal to or greater than 10 times and equal to or less than 200 times, preferably equal to or greater than 50 times and equal to or less than 150 times, and more preferably 100 times as a mixture ratio.

The amorphous semiconductor or the microcrystalline semiconductor can be formed using the above reactive gas with a plasma CVD apparatus which generates plasma by applying a high-frequency power with a power frequency of equal to or greater than 1 MHz and equal to or less than 200 MHz. Instead of applying the high-frequency power, a microwave power with a power frequency of equal to or greater than 1GHz and equal to or less than 5 GHz, typically 2.45 GHz may be applied. For example, the amorphous semiconductor or the microcrystalline semiconductor can be formed using glow discharge plasma in a reaction chamber of a plasma CVD apparatus with the use of a mixture of silicon hydride (typically, silane) and hydrogen. The glow discharge plasma is generated by applying high-frequency power with a frequency of equal to or greater than 1 MHz and equal to or less than 20 MHz, typically 13.56 MHz, or high-frequency power in the VHF band with a frequency of greater than 20 MHz and up to about 120 MHz, typically 27.12 MHz or 60 MHz.

The amorphous semiconductor or microcrystalline semiconductor can be formed by changing deposition conditions such as the flow rates of the various gases and applied power.

When an impurity semiconductor layer having one conductivity type, such as an n-type impurity semiconductor layer (typically, an n-type impurity silicon layer) or a p-type impurity semiconductor layer (typically, a p-type impurity silicon layer), is formed, the semiconductor layer may be formed by addition of a doping gas to the above reactive gas. In the case of an n-type impurity semiconductor layer, the semiconductor layer may be formed by addition of a doping gas containing an element belonging to Group 15 of the periodic table, such as phosphorus, arsenic, or antimony. In the case of a p-type impurity semiconductor layer, the semiconductor layer may be formed by addition of a doping gas containing an element belonging to Group 13 of the periodic table, such as boron or aluminum.

In addition, the i-type semiconductor (also referred to as an intrinsic semiconductor) indicates a semiconductor in which an impurity element imparting one conductivity type (an impurity element imparting p-type or n-type conductivity) included has a concentration of equal to or less than 1 × 10²⁰ /cm³, oxygen and nitrogen have a concentration of equal to or less than 9 × 10¹⁹ /cm³ and photoconductivity exceeds dark conductivity by 100 times or more. The amorphous semiconductor or microcrystalline semiconductor which forms the i-type semiconductor sometimes has weak n-type conductivity when an impurity element for controlling valence electrons is not added intentionally. Thus, the i-type semiconductor layer may be formed by adding the impurity element imparting p-type conductivity at the same time as the formation or after formation thereof. The impurity element imparting p-type conductivity is typically boron, and an impurity gas such as B₂H₆ or BF₃ may be mixed into the semiconductor material gas at 1 ppm to 1000 ppm. The concentration of boron is preferably 1 × 10¹⁴ /cm³ to 6 × 10¹⁶ /cm³, for example.

Note that in the case where the photoelectric conversion layer 130 is formed with the pin-junction amorphous semiconductor and the first structure body 160 side is a light incidence plane, a structure in which a p layer, an i layer, and an n layer are sequentially stacked from the first electrode 120 side is preferable.

Next, element-isolated photoelectric conversion elements are formed and integrated. An integration method and an element isolation method of the photoelectric conversion element are not particularly limited. In this embodiment, an example in which photoelectric conversion elements are each separated and adjacent photoelectric conversion elements are electrically connected in series is described. An example in which four photoelectric conversion elements are connected in series and integrated is described below with reference to the drawings of this embodiment.

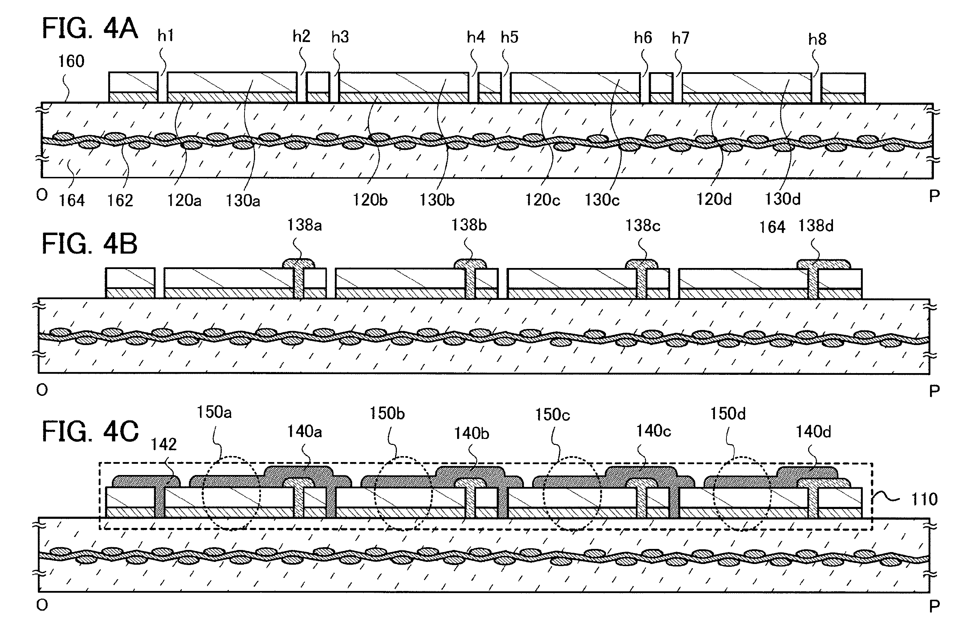

Openings h1 to h8 which penetrate layers are formed in the photoelectric conversion layer 130 and the first electrode 120 which are formed over the first structure body 160 (see FIG. 4A and FIG. 6B). Here, element isolation is performed through the openings h1, h3, h5, and h7 (for example, h(n-1) (n is an even integer)). As illustrated in FIG. 4A and FIG. 6B, the first electrode 120 is divided into a first electrode 120a, a first electrode 120b, a first electrode 120c, and a first electrode 120d; and the photoelectric conversion layer 130 is divided into a photoelectric conversion layer 130a, a photoelectric conversion layer 130b, a photoelectric conversion layer 130c, and a photoelectric conversion layer 130d at the same time. In addition, the openings h2, h4, h6, and h8 (for example, h(n) (n is an even integer)) are provided to connect the adjacent photoelectric conversion elements.

The openings h1 to h8 which are formed in the photoelectric conversion layer 130 and the first electrode 120 can be formed by a laser processing method such as laser scribing. There is no limitation on the kind of lasers used in the laser processing; however, an Nd-YAG laser, an excimer laser, or the like is preferably used. Note that when the laser processing is performed on the stack of the photoelectric conversion layer 130 over the first electrode 120, it is possible to prevent the first electrode 102 from being separated from the first structure body 160 during the processing.

Note that in the same step as forming the openings h1 to h8, the first structure body 160 is exposed by removing the photoelectric conversion layer 130 and the first electrode 120 in a region to be the peripheral portion of the photoelectric conversion element group. The region where the first structure body 160 is exposed is the peripheral portion of the photoelectric conversion element group, and the first structure body 160 is preferably exposed so as to surround the peripheral portion.

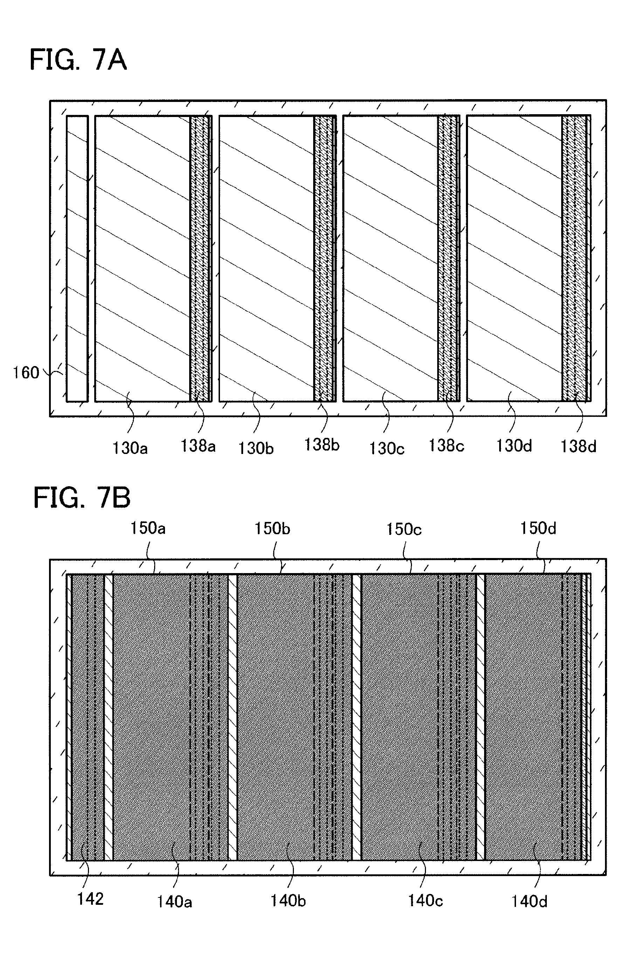

An insulating layer 138a, an insulating layer 138b, an insulating layer 138c, and an insulating layer 138d which respectively fill the opening h2, the opening h4, the opening h6, and the opening h8 which are formed in the photoelectric conversion layer 130 and the first electrode 120 are formed (see FIG. 4B and FIG. 7A). The insulating layers 138a to 138d can be formed using a resin material having an insulating property, such as an acrylic resin, a phenol resin, an epoxy resin, or a polyimide resin, by a printing method such as a screen printing method. For example, insulating resin patterns are formed by a screen printing method so that the openings h2, h4, h6, and h8 are filled with a resin composition in which cyclohexane, isophorone, high-resistance carbon black, aerosil, a dispersing agent, a defoaming agent, and a leveling agent are mixed with a phenoxy resin. After the insulating resin patterns are formed, the patterns are thermally cured in an oven at 160 °C for 20 minutes to obtain the insulating layers 138a to 138d.

A second electrode 140a, a second electrode 140b, a second electrode 140c, and a second electrode 140d are formed over the photoelectric conversion layer 130a, the photoelectric conversion layer 130b, the photoelectric conversion layer 130c, and the photoelectric conversion layer 130d, respectively. As described above, the following are formed: a photoelectric conversion element 150a in which the first electrode 120a, the photoelectric conversion layer 130a, and the second electrode 140a are stacked; a photoelectric conversion element 150b in which the first electrode 120b, the photoelectric conversion layer 130b, and the second electrode 140b are stacked; a photoelectric conversion element 150c in which the first electrode 120c, the photoelectric conversion layer 130c, and the second electrode 140c are stacked; and a photoelectric conversion element 150d in which the first electrode 120d, the photoelectric conversion layer 130d, and the second electrode 140d are stacked (see FIG. 4C and FIG. 7B).

The second electrode 140a of the photoelectric conversion element 150a is formed so as to fill the opening h3, whereby the second electrode 140a is connected to the first electrode 120b of the adjacent photoelectric conversion element 150b. The second electrode 140b of the photoelectric conversion element 150b is formed so as to fill the opening h5, whereby the second electrode 140b is connected to the first electrode 120c of the adjacent photoelectric conversion element 150c. The second electrode 140c of the photoelectric conversion element 150c is formed so as to fill the opening h7, whereby the second electrode 140c is connected to the first electrode 120d of the adjacent photoelectric conversion element 150d. That is, the opening h3 is filled with the same material as the second electrode 140a, the opening h5 is filled with the same material as the second electrode 140b, and the opening h7 is filled with the same material as the second electrode 140c. In such a manner, the second electrode 140a of the photoelectric conversion element 150a can be electrically connected to the first electrode 120b of the photoelectric conversion element 150b, the second electrode 140b of the photoelectric conversion element 150b can be electrically connected to the first electrode 120c of the photoelectric conversion element 150c, and the second electrode 140c of the photoelectric conversion element 150c can be electrically connected to the first electrode 120d of the photoelectric conversion element 150d. Each of the second electrodes can be electrically connected to the first electrode of the adjacent photoelectric conversion element, so that the photoelectric conversion elements 150a to 150c can be electrically connected to each other in series to form the photoelectric conversion element group 110.

Note that element isolation of the adjacent photoelectric conversion elements 150a and 150b is performed by the insulating layer 138a which is provided in the opening h2. Element isolation of the adjacent photoelectric conversion elements 150b and 150c is performed by the insulating layer 138b which is provided in the opening h4. Element isolation of the adjacent photoelectric conversion elements 150c and 150d is performed by the insulating layer 138c which is provided in the opening h6.

The second electrodes 140a to 140d are formed using a conductive material. Since the first structure body 160 side serves as the light incidence plane in this embodiment, a reflective electrode is preferably formed for the second electrodes 140a to 140d using a conductive material such as aluminum, silver, copper, titanium, or tungsten. The second electrodes 140a to 140d can be formed using the above conductive material by a sputtering method or a vacuum evaporation method, but are preferably formed using a conductive composition by a discharging method. By using a conductive composition by a discharging method for the second electrodes 140a to 140d, predetermined electrode patterns are directly formed by a printing method such as a screen printing method, an ink-jet method, or a dispenser method. For example, the second electrodes 140a to 140d can be formed using a conductive composition containing conductive particles of metal such as gold, silver, copper, tungsten, or aluminum as its main component. Note that in the case where a photoelectric conversion device which is manufactured has a large area, it is preferable that the resistance of the second electrodes 140a to 140d be reduced. Therefore, it is preferable to use a conductive composition in which a metal conductive particle of gold, silver, or copper having low resistivity, preferably low resistant silver or copper is dissolved or dispersed in a solvent. In order to sufficiently fill the laser-processed openings h1, h3, h5, and h7 with the conductive material, nanopaste containing conductive particles with an average diameter of 5 nm to 10 nm is preferably used.

Alternatively, the second electrodes 140a to 140d may be formed by discharging a conductive composition containing a conductive particle whose periphery is covered with another conductive material. For example, a conductive particle of Cu whose periphery is covered with Ag, which has a buffer layer formed of nickel or nickel boron between Cu and Ag, may be used. As the solvent, esters such as butyl acetate, alcohols such as isopropyl alcohol, an organic solvent such as acetone, or the like is used. The surface tension and viscosity of the conductive composition which is discharged are adjusted as appropriate by controlling the concentration of the solution and adding a surface-active agent or the like.

After the conductive composition which forms the second electrodes 140a to 140d is discharged, either a drying step or a baking step is performed under a normal pressure or a reduced pressure by laser beam irradiation, rapid thermal annealing (RTA), heating in a furnace, or the like. Both of the steps are heat treatment steps, and, for example, a drying step is performed at 100 °C for 3 minutes and a baking step is performed at 200 °C to 350 °C for 15 minutes to 120 minutes. Through this process, fusion and welding are accelerated by curing and shrinking a peripheral resin of the conductive particle after the solvent in the conductive composition is volatilized or the dispersant in the conductive composition is chemically removed. The drying and baking steps are performed in an oxygen atmosphere or a nitrogen atmosphere, or in the air atmosphere. Note that an oxygen atmosphere is preferable because the solvent in which conductive particles are dissolved or dispersed is easily removed.

Note that an electrode 142 is formed in the same step as the second electrodes 140a to 140d. The electrode 142 is formed so as to fill the opening h1, whereby the electrode 142 is connected to the first electrode 120a of the photoelectric conversion element 150a. The electrode 142 serves as one of extraction electrodes of the photoelectric conversion element group 110, which are connected in series, and the electrode 142 is electrically connected to one of output terminals which will be formed subsequently. In addition, the second electrode 140d of the photoelectric conversion element 150d serves as the other of the extraction electrodes of the photoelectric conversion element group 110, and the second electrode 140d is electrically connected to the other of the output terminals which will be formed subsequently.

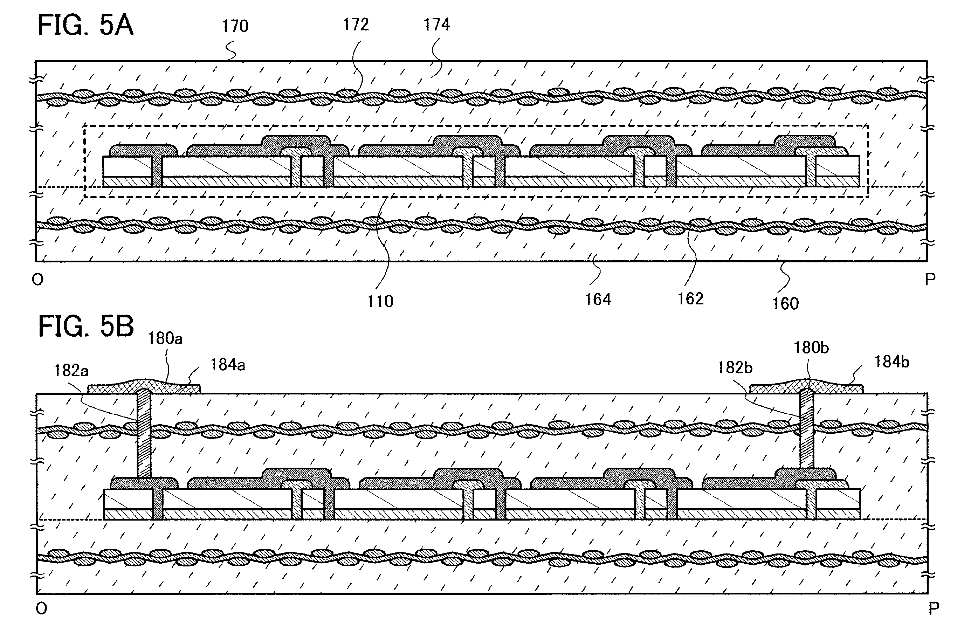

Next, the second structure body 170 is attached to the first structure body 160 provided with the photoelectric conversion element group 110, whereby the photoelectric conversion element group 110 is interposed between the first structure body 160 and the second structure body 170 (see FIG. 5A). Through this process, there is the region in which the first structure body 160 and the second structure body 170 are directly attached to each other in the peripheral portion of the photoelectric conversion element group 110.

The second organic resin 174 is cured in such a manner that the second structure body 170 in which the second fibrous body 172 is impregnated with the second organic resin 174 which is a thermosetting resin is heated and the second structure body 170 is pressure-bonded to a side of the first structure body 160, on which the photoelectric conversion element group 110 is provided. In the case where the second organic resin 174 is a thermoplastic resin, the plasticized second organic resin 174 can be cured in such a manner that the second structure body 170 is heated and pressure-bonded to the side of the first structure body 160, on which the photoelectric conversion element group 110 is provided, and cooling to reduce the temperature to a room temperature is performed. By heating and pressure bonding, the second organic resin 174 is uniformly spread so as to be in close contact with the photoelectric conversion element group 110 and the side of the first structure body 160, on which the photoelectric conversion element group 110 is provided, and is cured. A step of pressure-bonding the above second structure body 170 to an object (in this embodiment, the photoelectric conversion element group 110 and the side of the first structure body 160, on which the photoelectric conversion element group 110 is provided) is performed under an atmospheric pressure or a reduced pressure.

In this embodiment, since there is a region in which the first structure body 160 is exposed in the peripheral portion of the photoelectric conversion element group 110, the second structure body 170 has a region to be directly attached to the first structure body 160. Preferably, by exposing the first structure body 160 so as to surround the peripheral portion of the photoelectric conversion element group 110, the region in which the first structure body 160 and the second structure body 170 are attached to each other so as to surround the peripheral portion of the photoelectric conversion element group 110 can be formed. In addition, there is the region in which the first structure body 160 and the second structure body 170 are attached to each other so as to surround the peripheral portion of the photoelectric conversion element group 110. In such a manner, in an element formation region which includes the photoelectric conversion element group 110, all peripheries thereof (the upper, lower, and side surfaces but excluding a region for connecting to the output terminal) can be covered and sealed with structure bodies. Therefore, an effect that prevents deterioration or breakage of elements can be enhanced.

The output terminal 180a and the output terminal 180b which are electrically connected to the photoelectric conversion element group 110 are formed (see FIG. 5B).

The output terminal 180a and the output terminal 180b are not particularly limited as long as power generated in the photoelectric conversion element group 110 can be extracted outside. The output terminal can be formed using a conductive layer, a wiring, a lead wire, a conductive tape, a conductive adhesive, a solder, a conductivity paste, or the like as appropriate. For example, the second structure body 170 is provided with an opening that reaches each extraction electrode of the photoelectric conversion element group 110, and a wiring 182a and a wiring 182b are each provided so as to fill the opening. Further, a terminal 184a and a terminal 184b are formed in contact with the wiring 182a and the wiring 182b, respectively. The power generated in this photoelectric conversion device can be extracted outside by the output terminals 180a and 180b. Here, in the photoelectric conversion element group 110, the photoelectric conversion elements 150a, 150b, 150c, and 150d are electrically connected in series. The electrode 142 which is electrically connected to the first electrode 120a of the photoelectric conversion element 150a to function as an extraction electrode is electrically connected to the output terminal 180a, and the second electrode 140d of the photoelectric conversion element 150d is electrically connected to the output terminal 180b.

The opening that reaches each extraction electrode (the electrode 142 and the second electrode 140d in FIG. 5B) of the photoelectric conversion element group 110 provided in the second structure body 170 may be formed by a physical treatment such as a needle or a drill, a chemical treatment such as etching, or laser processing. The wirings 182a and 182b which fill the respective openings are not particularly limited, and wiring patterns may be directly formed by a printing method, an ink-jet method, a plating method, or the like, and the wirings 182a and 182b can be formed using, for example, a silver paste. The terminals 184a and 184b are not particularly limited too, and, for example, can be formed by a conductive adhesive tape or the like.

Note that in this embodiment, since the example in which the first structure body 160 side serves as the light incidence plane is described, an example in which the first electrode is a light-transmitting electrode and the second electrode is a reflective electrode is described. On the other hand, the first electrode may be a reflective electrode, and the second electrode may be a light-transmitting electrode.

In addition, in this embodiment, the example in which the photoelectric conversion element group 110 is formed by forming the first electrode 120 over the first structure body 160 and the second structure body 170 is attached to the second electrodes 140a to 140d is described. As another example, an inorganic insulating layer may be formed in both or either between the first structure body 160 and the photoelectric conversion element group 110 and/or between the second structure body 170 and the photoelectric conversion element group 110.

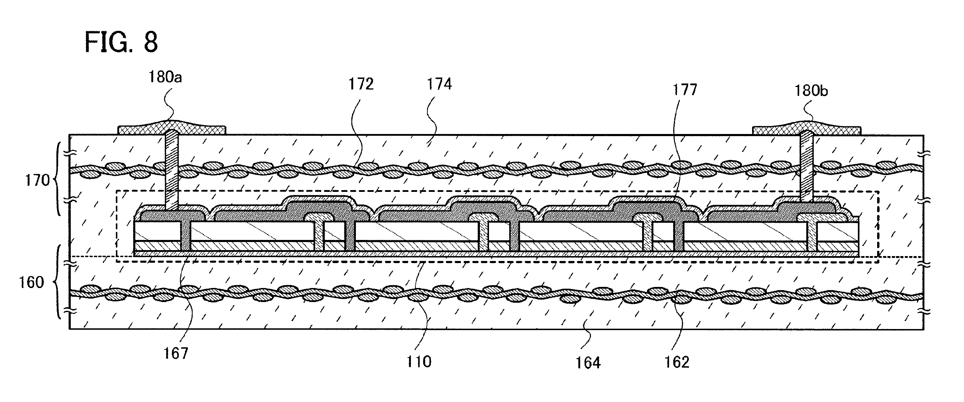

FIG. 8 illustrates an example in which a first inorganic insulating layer 167 is provided between the first structure body 160 and the photoelectric conversion element group 110 and a second inorganic insulating layer 177 is provided between the second structure body 170 and the photoelectric conversion element group 110. Oxidization or the like of the first electrode and the second electrode can be prevented by forming the inorganic insulating layer between the structure body and the photoelectric conversion element group 110. In addition, since a region in which the organic resin of the structure body and the photoelectric conversion element are in contact with each other can be reduced, intrusion of moisture into the element region can be suppressed.

In addition, the first inorganic insulating layer 167 is provided between the first structure body 160 and the photoelectric conversion element group 110, so that quality defects such as breakage or defective characteristics, or the like can be prevented and yield can be improved also in the manufacturing process. When the integrated structure of photoelectric conversion elements is formed by laser processing, a region where a laser beam reaches might be heated to equal to or greater than 1000 °C even in a moment. Therefore, when the photoelectric conversion element group is formed over the first structure body 160 which is used as an element formation substrate, there is a possibility that a laser beam also reaches the first structure body 160 and the first structure body 160 is damaged. In that case, the first structure body 160 might be transformed or broken and the photoelectric conversion element group (the first electrode) might be separated from the first structure body 160. In addition, the first electrode might be separated from the first structure body 160 to cause separated pieces and there might be a short circuit between the first electrode and the second electrode which will be subsequently formed. Accordingly, this also causes defective characteristics, low output, or the like of the photoelectric conversion device. The first inorganic insulating layer 167 can be made to function as a protective layer of the first structure body 160 by providing the first inorganic insulating layer 167, and defects in the manufacturing process such as laser processing can be prevented.

It is preferable that an inorganic insulating layer (here, the first inorganic insulating layer 167 and the second inorganic insulating layer 177) which is provided between each structure body and a photoelectric conversion element group be silicon oxide or silicon nitride. As typical examples of silicon oxide and silicon nitride, silicon oxide, silicon oxynitride, silicon nitride, silicon nitride oxide, and the like can be given. Not e that in this specification, silicon oxynitride is a substance which contains more oxygen than nitrogen. In the case where measurements are performed using Rutherford backscattering spectrometry (RBS) and hydrogen forward scattering (HFS), includes oxygen, nitrogen, silicon, and hydrogen at concentrations ranging from 50 atomic% to 70 atomic%, 0.5 atomic% to 15 atomic%, 25 atomic% to 35 atomic%, and 0.1 atomic% to 10 atomic%, respectively. Further, silicon nitride oxide means a substance that contains more nitrogen than oxygen and, in the case where measurements are performed using RBS and HFS, includes oxygen, nitrogen, silicon, and hydrogen at concentrations ranging from 5 atomic% to 30 atomic%, 20 atomic% to 55 atomic%, 25 atomic% to 35 atomic%, and 10 atomic% to 30 atomic%, respectively. Note that percentages of nitrogen, oxygen, silicon, and hydrogen fall within the ranges given above, where the total number of atoms contained in the silicon oxynitride or the silicon nitride oxide is defined as 100 atomic%. The above inorganic insulating layer is formed to have a single layer structure or a stacked structure by a sputtering method, a CVD method, an application method, a printing method, or the like.

Note that the inorganic insulating layer which is provided between each structure body and the photoelectric conversion element group is removed in the region where the pair of structure bodies is attached to each other in the periphery of the photoelectric conversion element group.

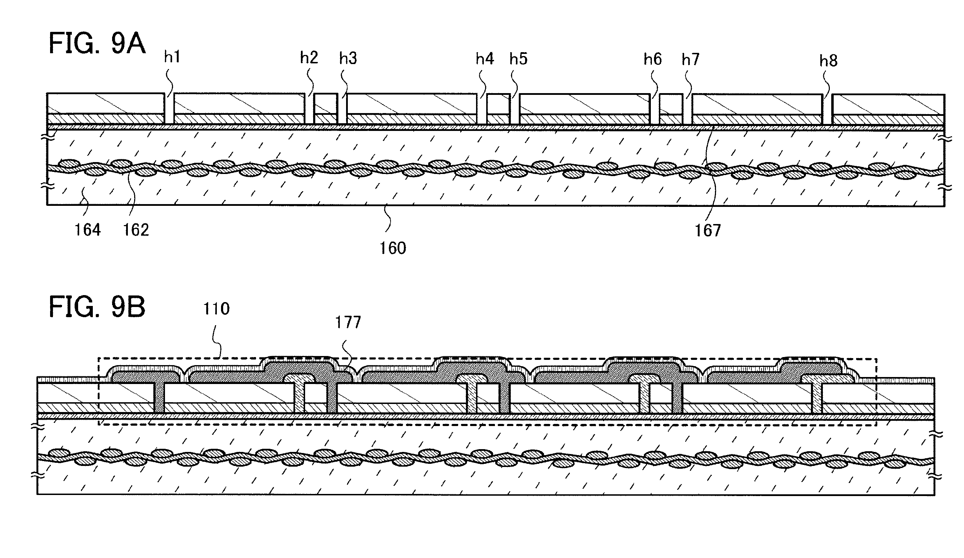

FIGS. 9A and 9B illustrate an example of a manufacturing method of the photoelectric conversion device illustrated in FIG. 8. The first inorganic insulating layer 167 is formed over the first structure body 160, and a first electrode and a photoelectric conversion layer are sequentially formed in stack over the first inorganic insulating layer 167. After that, the openings h1 to h8 for element isolation and integration are formed. Note that when the openings h1 to h8 are formed, the region which serves as the peripheral portion of the photoelectric conversion element group is not removed (see FIG. 9A).

In a manner similar to those of FIGS. 4B and 4C, the insulating layers 138a to 138d, the second electrodes 140a to 140d, and the electrode 142 are formed to form the photoelectric conversion element group 110 in which the photoelectric conversion elements 150a to 150d are electrically connected to each other. Then, the second inorganic insulating layer 177 is formed over the photoelectric conversion element group 110.

Then, in the peripheral portion of the photoelectric conversion element group 110, the first structure body 160 is exposed by removing the first inorganic insulating layer 167, the first electrode, the photoelectric conversion layer, and the second inorganic insulating layer 177. After that, by attaching the second structure body 170, a photoelectric conversion device illustrated in FIG. 8 can be manufactured.

In addition, in the photoelectric conversion device illustrated in FIG. 8, the first inorganic insulating layer 167 is formed over the first structure body 160, the photoelectric conversion element group 110 is formed as illustrated in FIGS. 4A to 4C, and the second inorganic insulating layer 177 is formed over the photoelectric conversion element group 110 (the second electrodes 140a to 140d, and the electrode 142). After the first structure body 160 is exposed by removing the first inorganic insulating layer 167 and the second inorganic insulating layer 177 in the peripheral portion of the photoelectric conversion element group 110, the photoelectric conversion device illustrated in FIG. 8 can be manufactured by attaching the second structure body 170.

Note that this embodiment can be combined with any of other embodiments as appropriate.

### [Embodiment 2]

In this embodiment, a structure which is different from that of the above embodiment will be described. Specifically, an embodiment in which a sealing layer having a structure which is different from that described in the above embodiment is used will be described. Note that descriptions for the same parts as the above embodiment are omitted or partially simplified.

In this embodiment, an example in which, as a protective layer, an impact diffusion layer is further provided outside a pair of structure bodies which seal the photoelectric conversion element group (a side opposite to a photoelectric conversion element group) is described. Specifically, an example in which, as a first sealing layer, a stacked structure of a first protective layer 191 and the first structure body 160 in which the first fibrous body 162 is impregnated with the first organic resin 164 is used is shown. In addition, an example in which, as a second sealing layer, a stacked structure of a second protective layer 192 and the second structure body 170 in which the second fibrous body 172 is impregnated with the second organic resin 174 is used is shown.

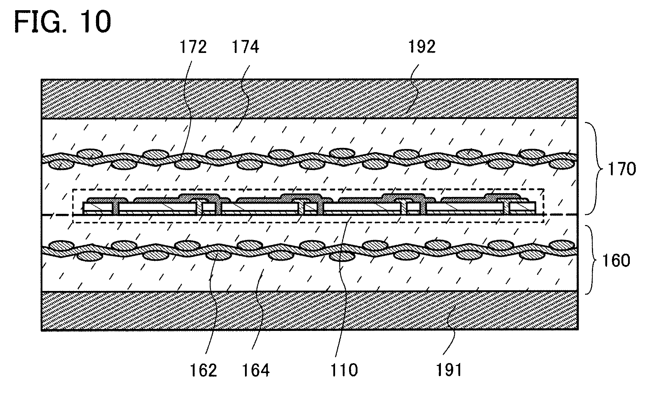

In FIG. 10, the photoelectric conversion element group 110 is interposed between the first structure body 160 and the second structure body 170. The first structure body 160 and the second structure body 170 have a region to be in close contact with each other in the peripheral portion of the photoelectric conversion element group 110. Then, the first protective layer 191 is provided further outside the first structure body 160 (a side opposite to the photoelectric conversion element group 110), and the second protective layer 192 is provided further outside the second structure body 170 (a side opposite to the photoelectric conversion element group 110).

As the protective layer according to this embodiment, an insulator having different characteristics with respect to external stress from that of a structure body in which a fibrous body is impregnated with an organic resin (here, the first structure body 160 and the second structure body 170) is provided. Specifically, an insulator which diffuses the external stress applied to a photoelectric conversion device and a photoelectric conversion element group and which can function as an impact diffusion layer that reduces the effect of the external stress is provided as a protective layer. As in this embodiment, by providing a structure body which can function as an impact resistance layer with respect to the external stress (here, the first structure body 160 and the second structure body 170) and an impact diffusion layer that diffuses the external stress (here, the first protective layer 191 and the second protective layer 192), resistance to the external stress can be increased without any loss of flexibility. Therefore, improvement in manufacturing yield and mechanical strength, durability, weather resistance, or the like as a product can be enhanced.

As the first protective layer 191 and the second protective layer 192, a material, the modulus of elasticity of which is low and the breaking strength of which is high, is preferably used. In addition, it is preferable that the first protective layer 191 have lower modulus of elasticity and higher breaking strength than the first structure body 160. It is preferable that the second protective layer 192 have lower modulus of elasticity and higher breaking strength than the second structure body 170. For example, a film having a rubber elasticity, the modulus of elasticity of which is equal to or greater than 5 GPa and equal to or less than 12 GPa and the modulus of rupture of which is equal to or greater than 300 MPa, is preferably used. In addition, the first structure body 160 and the second structure body 170 preferably have a modulus of elasticity of equal to or greater than 13 GPa and a modulus of rupture of less than 300 MPa.

Further, the first protective layer 191 and the second protective layer 192 are preferably formed using a high-strength material. As typical examples of the high-strength material, the following can be given: a polyvinyl alcohol resin, a polyester resin, a polyamide resin, a polyethylene resin, an aramid resin, a polyparaphenylene benzobisoxazole resin, a glass resin, and the like. By providing the first protective layer 191 and the second protective layer 192 which are formed using a high-strength material having elasticity, burden such as local pressing force can be diffused in the entire layer and absorbed. Therefore, the effect of the external stress applied to a photoelectric conversion device can be dispersed and reduced, so that incidence of quality defects such as breakage can be prevented during the manufacturing process and also after the photoelectric conversion device is completed as a product. In addition, the mechanical strength of the photoelectric conversion device can also be enhanced.

Specifically, as the first protective layer 191 and the second protective layer 192, the following can be used: an aramid resin, a polyethylene terephthalate (PET) resin, a polyethylene naphthalate (PEN) resin, a polyether sulfone (PES) resin, a polyphenylene sulfide (PPS) resin, a polyimide (PI) resin, or the like. In this embodiment, an aramid resin film (the modulus of elasticity: 10 GPa and the modulus of rupture: 480 MPa) can be used as the first protective layer 191 and the second protective layer 192. In addition, an epoxy resin can be used as the first organic resin 164 of the first structure body 160 and the second organic resin 174 of the second structure body 170.

As the first structure body 160, the structure body in which the first fibrous body 162 is impregnated with the first organic resin 164 is used. In a similar manner, as the second structure body 170, the structure body in which the second fibrous body 172 is impregnated with the second organic resin 174 is used. Therefore, the first structure body 160 and the first protective layer 191 can be directly attached to each other without an adhesive layer interposed therebetween by a heat treatment and a pressure treatment. In a similar manner, the second structure body 170 and the second protective layer 192 can be directly attached to each other without an adhesive layer interposed therebetween by a heat treatment and a pressure treatment. Then, the stacked structure of the first structure body 160 and the first protective layer 191 and the stacked structure of the second structure body 170 and the second protective layer 192 can be directly attached to the photoelectric conversion element group 110 without an adhesive layer interposed between each of the stacked structure and the photoelectric conversion element group 110 by a heat treatment and a pressure treatment. In addition, in the peripheral portion of the photoelectric conversion element group 110, the stacked structure of the first structure body 160 and the first protective layer 191 and the stacked structure of the second structure body 170 and the second protective layer 192 can be directly attached without an adhesive layer interposed therebetween by a heat treatment and a pressure treatment. By preferably having a structure in which the first structure body 160 and the second structure body 170 are in close contact with each other so as to surround the peripheral portion of the photoelectric conversion element group 110 to seal the photoelectric conversion element group 110, adhesion of the sealing layers can be enhanced and resistance to external stress can be increased.

An example of a manufacturing method of the photoelectric conversion device illustrated in FIG. 10 is shown below.

As the first sealing layer, the first structure body 160 provided with the first protective layer 191 is prepared. The first structure body 160 provided with the first protective layer 191 is cured in advance until the first structure body 160 can be used as an element formation substrate. Note that the first structure body 160 can have a stacked structure by being attached to the first protective layer 191 by heating and pressure bonding.

The photoelectric conversion element group 110 is formed over the first structure body 160, where the stacked structure of the first structure body 160 and the first protective layer 191 serves as an element formation substrate. The photoelectric conversion element group 110 may be formed in accordance with Embodiment 1 described above as long as the region in which the first structure body 160 is exposed in the peripheral portion of the photoelectric conversion element group 110 is formed by the step of being sealed with the second sealing layer.

The second structure body 170 and the second protective layer 192 are attached to the first protective layer 191 and the first structure body 160 provided with the photoelectric conversion element group 110; and the photoelectric conversion element group 110 is sealed between the first structure body 160 and the first protective layer 191, and the second structure body 170 and the second protective layer 192. Note that through the above process, there is the region in which the first structure body 160 and the second structure body 170 are directly attached to each other in the peripheral portion of the photoelectric conversion element group 110.

The second structure body 170 is a structure body in which the second fibrous body 172 is impregnated with the second organic resin 174, in which the second organic resin 174 can be cured by heating and pressure-bonding to an object. Over the first protective layer 191 and the first structure body 160 provided with the photoelectric conversion element group 110, a stacked body in which the second structure body 170 and the second protective layer 192 are stacked is heated and pressure-bonded to seal the photoelectric conversion element group 110.

Note that as illustrated in FIG. 10, the first structure body 160 and the second structure body 170 preferably have a structure in which the photoelectric conversion element group 110 is disposed at the center, and in which the first structure body 160 and the second structure body 170 are in contact with each other in the peripheral portion where there is no photoelectric conversion element group 110 so as to seal the photoelectric conversion element group 110. In other words, it is preferable that a pair of sealing layers, the first structure body 160 and the first protective layer 191, and the second structure body 170 and the second protective layer 192, has a symmetrical structure and the photoelectric conversion element group 110 be disposed at the center of the symmetrical structure. In the symmetrical structure, it is preferable that the material and the thickness be the same. With such a structure, the external stress applied to a photoelectric conversion device and a photoelectric conversion element can be made uniform. In particular, the structure has an effect on a transformation of curvature such as bending or warpage; thus, destruction of an element can be prevented. This is because the degree of the transformation can be reduced by disposing the element at the center.

Note that the impact diffusion layer provided outside the structure body can have an effect of increasing the mechanical strength with respect to the external stress of the photoelectric conversion device and also resistance to a pressure treatment in the manufacturing process. Therefore, breakage and defective characteristics of a photoelectric conversion device in the manufacturing process can be prevented, which results in improvement of yield.

As described above, a highly reliable photoelectric conversion device can be provided without any loss of flexibility. In addition, quality defects in a manufacturing process can be prevented; thus, photoelectric conversion devices can be manufactured with high yield.

Note that also in the structure described in this embodiment, an inorganic insulating layer can be provided between each structure body and a photoelectric conversion element group as illustrated in FIG. 8 of Embodiment 1 described above.

Note that this embodiment can be combined with any of other embodiments as appropriate.

### [Embodiment 3]

In this embodiment, a photoelectric conversion device having a structure which is different from those of the above embodiments will be described. Specifically, a structure which is aimed to improve further reliability will be described. Note that descriptions for the same parts as the above embodiments are omitted or partially simplified.

In this embodiment, an example in which a photoelectric conversion device is provided with a conductive layer is shown. A conductive layer is provided on the outermost surface of a photoelectric conversion device; specifically conductive layers are provided on the surface outside a pair of sealing layers (a side opposite to a photoelectric conversion element group). As shown in Embodiment 1 described above, when a structure body in which a fibrous body is impregnated with an organic resin is used as a sealing layer, a conductive layer can be provided outside the surface of the structure body. In addition, as shown in Embodiment 2 described above, when a protective layer is provided outside a structure body in which a fibrous body is impregnated with an organic resin, a conductive layer can be provided outside the protective layer. Note that in this embodiment, an example using only a structure body in which a fibrous body is impregnated with an organic resin as a sealing layer will be described.

Application of static electricity to a photoelectric conversion device or a photoelectric conversion element from outside can be blocked by providing a conductive layer. Specifically, a conductive layer can diffuse static electricity applied by electrostatic discharge to let it go. In addition, the conductive layer prevents local electric charges (localization of electric charges) (prevents local potential difference), so that electrostatic breakdown of a photoelectric conversion device and a photoelectric conversion element can be prevented. Therefore, it is possible to prevent incidence of operation defects due to electrostatic breakdown of the element or quality defects such as defective characteristics even when static electricity is applied to a photoelectric conversion device or a photoelectric conversion element during the manufacturing process and after distribution. In other words, a photoelectric conversion device in which reliability is high and yield in the manufacturing process of the photoelectric conversion device is improved can be provided.

Note that the conductive layer is formed to a thickness and formed using a material which can block static electricity. When the conductive layer is provided on a light incidence plane, the conductive layer is formed so as to have enough light-transmitting property to achieve a photoelectric effect. Further, the thickness of the conductive layer is preferably set based on the resistivity. For example, in the case where the resistivity of a conductive material used as the conductive layer is high, the conductive layer is preferably formed thick so that static electricity is effectively diffused. When the conductive layer is formed to be too thin using a conductive material whose resistivity is high, the sheet resistance is increased. Therefore, static electricity cannot be effectively diffused in the case where electrostatic discharge is generated, and a large amount of current flows in a photoelectric conversion device and a photoelectric conversion element, which might cause electrostatic breakdown.

For the purpose of effectively preventing electrostatic breakdown of a photoelectric conversion device and a photoelectric conversion element, the thickness of the conductive layer is preferably set so that the sheet resistance of the conductive layer is equal to or less than 1.0 × 10⁷ Ω/square, preferably equal to or less than 1.0 × 10⁴ Ω/square, more preferably equal to or less than 1.0 × 10² Ω/square. In addition, in the case where the conductive layer is also provided on the light incidence plane of the photoelectric conversion device, in consideration of light incidence, the thickness of the conductive layer is preferably determined so as to have the above sheet resistance and to be as thin as possible. Such a conductive layer is formed, whereby electrostatic breakdown of the photoelectric conversion device resulted from electrostatic discharge can be effectively prevented. In addition, photoelectric conversion devices can be manufactured with high yield in the manufacturing process.

In addition, the conductive layer is not electrically connected to the photoelectric conversion device and the photoelectric conversion element group 110. An output terminal, although not illustrated here, is not electrically connected to the conductive layer either.

The conductive layer is provided on the surface of the photoelectric conversion device, in a region overlapped with the photoelectric conversion element group. Specifically, in the outside surface of the pair of sealing layers (a side opposite to the photoelectric conversion element group), the conductive layer is provided in a region overlapped with the photoelectric conversion element group interposed between the pair of sealing layers. Note that the conductive layer can be provided so as to cover the entire surface (including the upper, lower, and side surfaces) of the photoelectric conversion device (the pair of sealing layers). In other words, the conductive layer can be provided so as to cover the surface of the photoelectric conversion device. Alternatively, the conductive layer can be provided so as to cover either or both of the upper and lower surfaces of the photoelectric conversion device (the pair of sealing layers). In addition, the conductive layers may be provided on both of the upper and lower surfaces of the photoelectric conversion device to form a pair of conductive layers so that a conductive region which electrically connects the pair of conductive layers is formed. The conductive region may be provided on the side surface of the photoelectric conversion device, or a structure to penetrate through the photoelectric conversion device may be employed. Note that in the case where the photoelectric conversion device is manufactured with a so-called multi-panel method in which a plurality of photoelectric conversion devices are manufactured in one manufacturing process, the side surface of the photoelectric conversion device is a cut surface which is generated at the time of being divided into separate photoelectric conversion devices. The cut surface may be entirely covered or partially covered with the conductive layer.

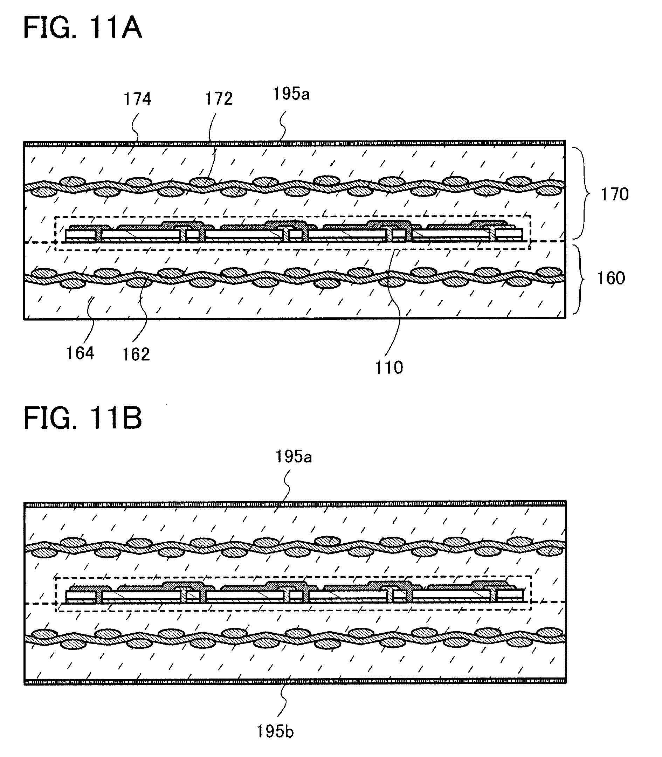

An example in which a conductive layer 195a is provided outside the second structure body 170 (a side opposite to the photoelectric conversion element group 110) is shown in FIG. 11A. In addition, an example in which a conductive layer 195b is provided outside the first structure body 160 and the conductive layer 195a is provided outside the second structure body 170 is shown in FIG. 11B.

In FIG. 11B, the example in which the conductive layer 195a and the conductive layer 195b that face each other are not electrically connected to each other is shown; however, the conductive layer 195a and the conductive layer 195b may be formed to be electrically connected to each other.

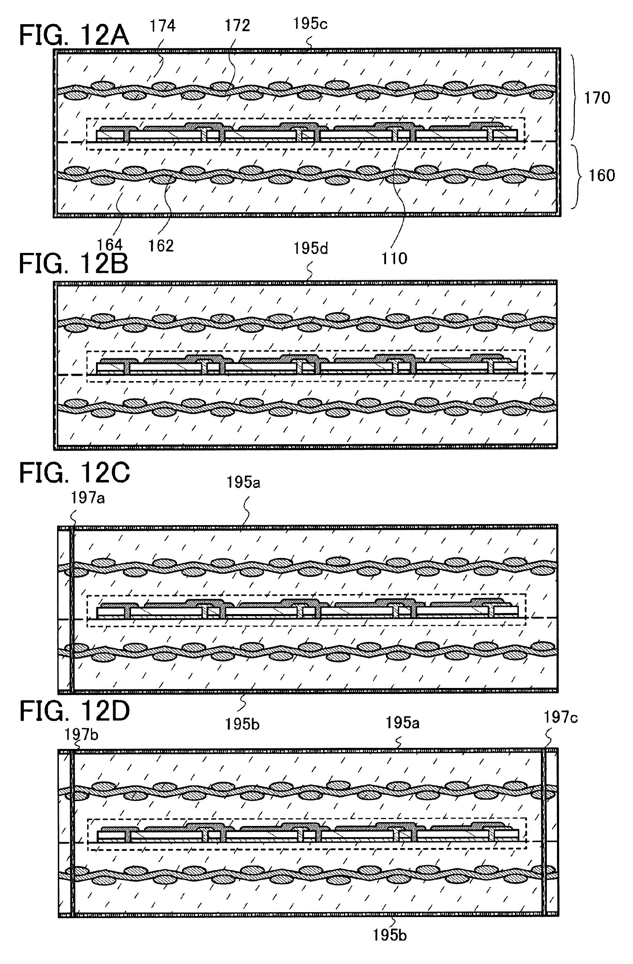

FIG. 12A illustrates an example in which a conductive layer 195c is formed so as to cover all the peripheral portions (the upper, lower, and side surfaces) of a photoelectric conversion device. FIG. 12B illustrates an example in which a conductive layer 195d is formed so as to cover the upper surface, the lower surface, and at least one side surface of a photoelectric conversion device. In addition, FIG. 12C illustrates an example in which a pair of the conductive layer 195a and the conductive layer 195b which is formed on the upper and lower surfaces of the photoelectric conversion device is electrically connected to each other through an electrode layer 197a that penetrates through a photoelectric conversion device. Moreover, FIG. 12D illustrates an example in which a pair of the conductive layer 195a and the conductive layer 195b is electrically connected to each other through the electrode layer 197a and an electrode layer 197b that penetrate through a photoelectric conversion device. Through holes in which the electrode layers 197a to 197c that penetrate a photoelectric conversion device are formed may be processed by a physical treatment with a needle, a drill, or the like or may be processed by a chemical treatment such as etching using a chemical. Alternatively, a laser beam may be used for processing the through holes.

In the photoelectric conversion element group 110 of FIGS. 12A to 12D, both of the upper and lower surfaces are provided with conductive layers which are electrically connected to each other. Therefore, a large area of the photoelectric conversion element group 110 is protected against external static electricity. Thus, a high effect of preventing electrostatic breakdown can be obtained.

After the photoelectric conversion element group is sealed, being interposed between the pair of sealing layers, the conductive layer may be formed on each surface of the sealing layer by a sputtering method or the like. In the case where a conductive layer is provided on both surfaces of a photoelectric conversion device, conductive layers may be formed through a plurality of steps by a sputtering method or the like.

In addition, as shown in Embodiment 2, a protective layer which functions as an impact diffusion layer can be further provided outside a structure body in which a fibrous body is impregnated with an organic resin. In this case, a conductive layer may be formed after the protective layer is attached to the structure body.

The conductive layer may have conductivity, and therefore a conductive layer formed using a conductive material can be used. For example, as the conductive layer, a conductive layer made of a thin film of metal, metal nitride, metal oxide, or the like, or a stacked film of any of the thin films can be used. Specifically, as the conductive layer, a metal material of an element selected from Ti, Mo, W, Al, Cu, Ag, Au, Ni, Pt, Pd, Ir, Rh, Ta, Cd, Zn, Fe, Si, Ge, Zr, or Ba can be used. Alternatively, an alloy material, a compound material, a nitride material, an oxide material, or the like containing any of the elements as its main component can be given.

As the nitride material, TaN, TiN, and the like can be given.

As the oxide material, indium tin oxide (ITO), indium tin oxide containing silicon oxide (ITSO), organoindium, organotin, zinc oxide, or the like can be used. Alternatively, indium oxide containing zinc oxide (IZO (indium zinc oxide)), zinc oxide containing gallium, tin oxide, indium oxide containing tungsten oxide, indium zinc oxide containing tungsten oxide, indium oxide containing titanium oxide, indium tin oxide containing titanium oxide, or the like may be used.

Alternatively, a semiconductor layer having conductivity, which is obtained by adding an impurity element or the like to a semiconductor, can be used as the conductive layer. For example, a polycrystalline silicon layer doped with an impurity element such as phosphorus can be used.

Still alternatively, a conductive macromolecule may be used for the conductive layer. As the conductive macromolecule, a so-called π-electron conjugated conductive macromolecule can be used. For example, polyaniline and/or a derivative thereof, polypyrrole and/or a derivative thereof, polythiophene and/or a derivative thereof, a copolymer of two or more kinds of those materials, and the like can be given.

The conductive layer can be formed by various dry processes such as a sputtering method, a plasma CVD method, or an evaporation method, or various wet processes such as an application method, a printing method, or a droplet discharge method (an ink-jet method). The conductive layer may also be formed by a plating method such as electrolytic plating or electroless plating.

Further, a protective layer may be stacked over the conductive layer. For example, it is preferable that a titanium film be formed as the conductive layer and a titanium oxide film be stacked over the titanium film as a protective layer. The conductive layer can be prevented from being degraded by providing a protective layer.

Note that in the case where the conductive layer is provided on the light incidence plane of a photoelectric conversion device, the conductive layer is formed to a thickness and formed using a material so as to have enough light-transmitting property to achieve a photoelectric effect. In addition, the conductive layer is formed without electrical connection to an output terminal.

In a photoelectric conversion device according to this embodiment, a conductive layer provided on the surface of the photoelectric conversion device can prevent electrostatic breakdown of the photoelectric conversion device and a photoelectric conversion element due to electrostatic discharge (damage to the photoelectric conversion element, malfunction or low output of the photoelectric conversion device, or the like). Therefore, resistance to external stress typified by electrical stress can be increased; thus, a highly reliable photoelectric conversion device can be provided. Also in the manufacturing process, it is possible to prevent quality defects such as defective characteristics due to external stress typified by electrical stress, and thus highly reliable photoelectric conversion devices can be manufactured with high yield.

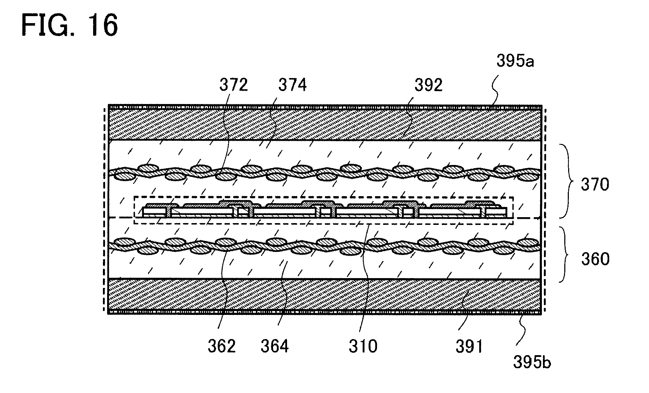

In addition, here, a specific example of a photoelectric conversion device provided with the conductive layer and the protective layer which functions as an impact diffusion layer in Embodiment 2 is illustrated in FIG. 16.

In FIG. 16, the photoelectric conversion element group 110 is sealed between a first structure body 360 and a second structure body 370. Further, a first protective layer 391 is provided outside the first structure body 360, and a second protective layer 392 is provided outside the second structure body 370. A conductive layer 395b is provided outside the first protective layer 391, and a conductive layer 395a is provided outside the second protective layer 392. At least part of the conductive layer 395a and the conductive layer 395b are electrically connected, and the conductive layer 395a and the conductive layer 395b have the same potential.

When the conductive layer 395a and the conductive layer 395b have the same potential, the effect of protection against static electricity can be obtained. Before the photoelectric conversion element is charged up with static electricity to be damaged, the photoelectric conversion element can be protected by making the upper and lower surfaces of the photoelectric conversion device have the same potential.

FIG. 16 illustrates an example of the photoelectric conversion device in which a structure body in which a fibrous body is impregnated with an organic resin is used for each of the first structure body 360 and the second structure body 370; an aramid film is used for each of the first protective layer 391 and the second protective layer 392; and a titanium film is used for each of the conductive layers 395a and 395b. The thickness of the first structure body 360 and the second structure body 370 can be equal to or greater than 10 µm and equal to or less than 30 µm; the thickness of the first protective layer 391 and second protective layer 392 can be equal to or greater than 3 µm and equal to or less than 15 µm; and the thickness of the photoelectric conversion element group 310 can be equal to or greater than 50 nm and equal to or less than 5 µm. In this case, as compared to the thickness of the photoelectric conversion element group, each of the first structure body 360, the second structure body 370, the first protective layer 391, and the second protective layer 392 is thick. Therefore, a photoelectric conversion device which has high resistance to warpage can be provided by disposing a photoelectric conversion element almost at the center.

Note that this embodiment can be combined with any of other embodiments as appropriate.

### [Embodiment 4]

In this embodiment, a photoelectric conversion device having a structure which is different from those described in the above embodiments will be described. Note that descriptions for the same parts as the above embodiments are omitted or partially simplified.

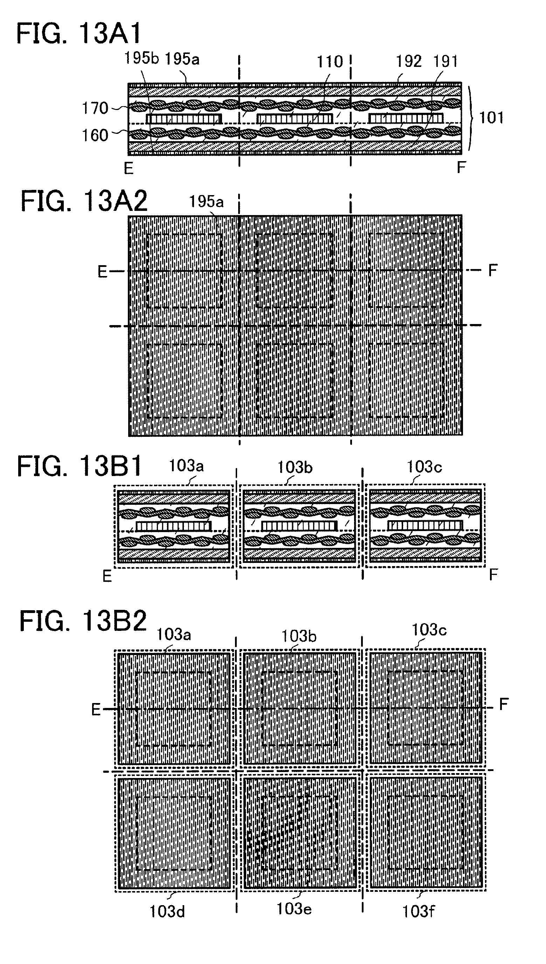

In this embodiment, an example of a manufacturing method of the structure in Embodiment 2, in which a conductive layer is provided on each of the both sides (the upper and lower surfaces) of a photoelectric conversion device and the conductive layers are electrically connected to each other, is illustrated in FIGS. 13A1, 13A2, 13B1, and 13B2. In addition, in this embodiment, an example of a manufacturing method using a multi-panel method in which a plurality of photoelectric conversion devices are manufactured in one manufacturing process is shown. In FIGS. 13A1, 13A2, 13B1, and 13B2, FIGS. 13A2 and 13B2 are plan views, and FIGS. 13A1 and 13B1 are cross-sectional views taken along corresponding lines EF in FIGS. 13A2 and 13B2.

In FIGS. 13A1 and 13A2, an aggregation of photoelectric conversion devices in the process of manufacturing a plurality of photoelectric conversion devices in one manufacturing process is illustrated. In a stacked body 101, a plurality of photoelectric conversion element groups 110 are sealed by being interposed between a first sealing layer using the stacked structure of the first structure body 160 and the first protective layer 191 and a second sealing layer using the stacked structure of the second structure body 170 and the second protective layer 192. In the plurality of photoelectric conversion element groups 110, there is a region in which the first structure body 160 and the second structure body 170 are in close contact with each other between the adjacent photoelectric conversion element groups 110. By preferably having the region in which the first structure body 160 and the second structure body 170 are in close contact with each other so as to surround the peripheral portion of the separate photoelectric conversion element groups 110, the photoelectric conversion element groups 110 are sealed separately. The stacked body 101 is in the state in which there is an aggregation of photoelectric conversion device having a plurality of photoelectric conversion devices, which is before the plurality of photoelectric conversion devices are divided into separate photoelectric conversion devices.

The conductive layer 195a is formed on the outside surface of the first protective layer 191 which is the outermost surface of the stacked body 101. The conductive layer 195b is formed on the outside surface of the second protective layer 192.

The stacked body 101 in which the conductive layer 195a and the conductive layer 195b are formed is divided into a photoelectric conversion device 103a, a photoelectric conversion device 103b, a photoelectric conversion device 103c, a photoelectric conversion device 103d, a photoelectric conversion device 103e, and a photoelectric conversion device 103f, separately (see FIGS. 13B1 and 13B2). The photoelectric conversion devices 103a to 103f each have the separated stacked body 101.

In this embodiment, a step of electrically connecting the conductive layer 195a and the conductive layer 195b to each other is performed by a dividing step (a dividing step into separate photoelectric conversion devices) of the stacked body (the aggregation of photoelectric conversion devices).

As a dividing means of the stacked body 101, it is preferable to use a means to melt the first protective layer 191, the second protective layer 192, the first structure body 160, and the second structure body 170 (it is more preferable to use a means to melt the conductive layers 195a and 195b). In this embodiment, laser beam irradiation is used for dividing the stacked body 101.

There is no particular limitation on the conditions, such as wavelength, intensity, and beam size of the laser beam used for the above dividing step. The laser light irradiation may be performed under such conditions that the stacked body 101 can be divided. As a laser beam used for the dividing step, it is possible to use, for example, an Ar laser, a Kr laser, a CO₂ laser, a YAG laser, a YVO₄ laser, a YLF laser, a YAlO₃ laser, a GdVO₄ laser, a Y₂O₃ laser, a ruby laser, an alexandrite laser, a Ti:sapphire laser, a helium-cadmium laser, an excimer (ArF, KrF, or XeCl) laser, a copper vapor laser, a gold vapor laser, or the like can be used.

As described in this embodiment, by dividing the stacked body 101 into separate photoelectric conversion devices 103a to 103f by laser beam irradiation, the resistance between the conductive layer 195a and the conductive layer 195b is decreased, whereby the conductive layer 195a and the conductive layer 195b are electrically connected to each other. Accordingly, the step of dividing into the separate photoelectric conversion devices and the step of electrically connecting the conductive layer 195a and the conductive layer 195b can be performed at a time.

Through the above steps, the separate photoelectric conversion devices 103a to 103f can be manufactured.

In this embodiment, a conductive layer provided on the surface of a photoelectric conversion device can prevent electrostatic breakdown of the photoelectric conversion device and a photoelectric conversion element due to electrostatic discharge.

### [Embodiment 5]

In this embodiment, a photoelectric conversion device having a structure which is different from those described in the above embodiments will be described. Specifically, a structure in which adhesion is enhanced in an adhesive region of the first sealing layer and the second sealing layer (an adhesive region of the first structure body and the second structure body) in end portions of a photoelectric conversion device will be described. Note that descriptions for the same parts as the above embodiments are omitted or partially simplified.

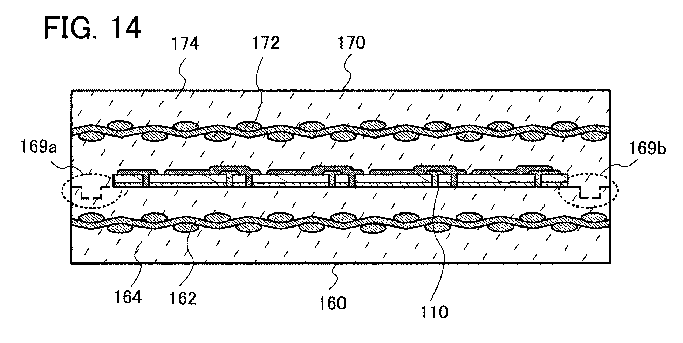

FIG. 14 corresponds to FIG. 1B of Embodiment 1. This photoelectric conversion device includes the photoelectric conversion element group 110 interposed between the first structure body 160 and the second structure body 170 that are provided to face each other. In the peripheral portion of the photoelectric conversion element group 110, there is a region where the first structure body 160 and the second structure body 170 are attached to each other.

In the end portions of the photoelectric conversion device illustrated in FIG. 14, specifically, in the peripheral region where there is no photoelectric conversion element group 110, a depression 169a and a depression 169b are provided in the first structure body 160. Then, the second structure body 170 that is provided to face the first structure body 160 and which interposes the photoelectric conversion element group 110 between the first structure body 160 and the second structure body 170 is attached so as to fill the depressions 169a and 169b of the first structure body 160. With such a structure, the first structure body 160 and the second structure body 170 are attached to each other with a contact area thereof increased in the peripheral portion of the photoelectric conversion element group 110. Therefore, adhesion between the first structure body 160 and the second structure body 170 can further be enhanced; thus, strong bond can be obtained. As an effect, a defect in a manufacturing process, such as separation due to a defect in adhesion, can be prevented and yield can be improved. In addition, defects such as separation can be prevented even after distribution as a product. Therefore, a highly reliable photoelectric conversion device in which resistance to external stress is high, and durability and weather resistance is enhanced can be provided.

The depressions 169a and 169b of the first structure body 160 may be formed before the second structure body 170 is attached to the first structure body 160. Specifically, the depressions 169a and 169b can be formed by partially removing the end portions of the first structure body 160 which serve as the peripheral portion of an element formation region (the photoelectric conversion element group 110). As a processing means of the depressions 169a and 169b, physical removal may be performed, or chemical etching (a dry etching method or a wet etching method) may be performed. For example, the depressions 169a and 169b can be formed by partially removing the first structure body 160 by laser processing such as a laser scribing method including laser ablation. The adhesion between the first structure body 160 and the second structure body 170 is enhanced by the formation of the depressions 169a and 169b in the first structure body 160 in this embodiment, with the contact area of the first structure body 160 and the second structure body 170 increased. Thus, the shape of the depressions is not limited to this embodiment, and a plurality of depressions may be formed.

To the first structure body 160 on which the photoelectric conversion element group 110 is provided and in which the depressions 169a and 169b are provided in the peripheral portion of the photoelectric conversion element group 110, the second structure body 170 in which the second fibrous body 172 is impregnated with the second organic resin 174 is attached by a heat treatment and a pressure treatment. Since the organic resin 174 of the second structure body 170, which is semi-cured at the time of attachment, has fluidity, the organic resin 174 is cured in close contact so as to fill the depressions 169a and 169b of the first structure body 160.

Note that although the description of this embodiment is made with the example of FIGS. 1A to 1C using a structure body as a sealing layer, this embodiment can be applied to a structure in which a protective layer which functions as an impact diffusion layer is provided outside a structure body or a structure in which a conductive layer is provided outside a structure body or a protective layer.

Note that this embodiment can be combined with any of other embodiments as appropriate.

### [Embodiment 6]

In this embodiment, a structure which is different from those of the above embodiments will be described. Note that descriptions for the same parts as the above embodiment are omitted or partially simplified.

As a photoelectric conversion element of this photoelectric conversion device, a photoelectric conversion element which generates power by photoinduced charge transfer between two molecules of a donor molecule and an acceptor molecule can be applied; thus, a photoelectric conversion layer can be formed using an organic semiconductor. Specifically, a p-n junction is formed with a p-type organic semiconductor and an n-type organic semiconductor. Note that as a photoelectric conversion layer, a heterojunction structure in which a p-type organic semiconductor and an n-type organic semiconductor are stacked or a bulk heterojunction structure in which a p-type organic semiconductor and an n-type organic semiconductor are mixed may be employed. By forming a bulk heterojunction structure, a defect of a short carrier diffusion length of an organic semiconductor layer can be compensated, and photoelectric conversion efficiency can be improved. A functional layer such as an electron blocking layer, a hole transporting layer, an electron transporting layer, a hole blocking layer, or a buffer layer may be included besides the photoelectric conversion layer using an organic semiconductor.

As an organic semiconductor material used in this embodiment, both a low molecular compound and a macromolecular compound can be used, and the type thereof is not particularly limited. For example, as the organic semiconductor material, a polycyclic aromatic compound, a conjugated double bond compound, a macrocyclic compound, a metallophthalocyanine complex, a charge transfer complex, condensed ring tetracarboxylic diimides, oligothiophenes, fullerenes, carbon nanotubes, and the like can be given.

As the p-type organic semiconductor, an organic semiconductor having an electron-donating property (a donor organic semiconductor) can be used. Specifically, the following materials can be given: a triarylamine compound, a benzidine compound, a pyrazoline compound, a styrylamine compound, a hydrazone compound, a triphenylmethane compound, a carbazole compound, a polysilane compound, a thiophene compound, a phthalocyanine compound, a cyanine compound, a merocyanine compound, an oxonol compound, a polyamine compound, an indole compound, a pyrrole compound, a pyrazole compound, a polyarene compound, a condensed aromatic carbocyclic compound (a naphthalene derivative, an anthracene derivative, a phenanthrene derivative, a tetracene derivative, a pyrene derivative, a perylene derivative, and a fluoranthene derivative), a metal complex in which a nitrogen-containing heterocyclic compound is used as a ligand, and the like. Note that the present invention is not limited to these, and as long as an organic compound which has smaller ionization potential than the organic compound used as an n-type organic semiconductor (an acceptor organic semiconductor) is used, the organic compound which has smaller ionization potential can be used as a donor organic semiconductor.

As an n-type organic semiconductor, an organic semiconductor having an electron acceptor property (an acceptor organic semiconductor) can be used. Specifically, the following materials can be given: condensed aromatic carbocyclic compounds (a naphthalene derivative, an anthracene derivative, a phenanthrene derivative, a tetracene derivative, a pyrene derivative, a perylene derivative, and a fluoranthene derivative), 5- to 7-membered heterocyclic compounds which contain any of a nitrogen atom, an oxygen atom, or a sulfur atom (e.g., pyridine, pyrazine, pyrimidine, triazine, quinoline, quinoxaline, quinazoline, phthalazine, cinnoline, isoquinoline, pteridine, acridine, phenazine, phenanthroline, tetrazole, pyrazole, imidazole, thiazole, oxazole, indazole, benzimidazole, benzotriazole, benzoxazole, benzothiazole, carbazole, purine, triazolopyridazine, triazolopyrimidine, tetrazaindene, oxadiazole, imidazopyridine, pyrrolopyridine, thiadiazolopyridine, dibenzazepine, tribenzazepine, and the like), a polyarylene compound, a fluorene compound, a cyclopentadiene compound, silyl compound, a metal complex in which a nitrogen-containing heterocyclic compound is used as a ligand, and the like. Note that the present invention is not limited to these, and as long as an organic compound has higher electron affinity than the organic compound used as a p-type organic semiconductor (a donor organic semiconductor), the organic compound which has higher electron affinity can be used as an acceptor organic semiconductor. Fullerenes, carbon nanotubes, or the like can also be used.

Any of a variety of methods can be employed for forming the photoelectric conversion layer using an organic semiconductor re gardless of whether it is a dry process or a wet process. In addition, a different formation method may be employed for each layer. As a dry process, a vacuum evaporation method, a sputtering method, or the like can be employed. In addition, as a wet process, an inkjet method, a spin coating method, a printing method, or the like can be used. The photoelectric conversion layer using an organic semiconductor material as described above can be formed through a low temperature process, which is preferable.

Note that this embodiment can be combined with any of other embodiments as appropriate.

### [Embodiment 7]

In this embodiment, an example of manufacturing a photoelectric conversion device according to one embodiment of the present invention by a roll-to-roll method will be described. In this embodiment, an example of manufacturing a photoelectric conversion device having a structure illustrated in FIGS. 1A to 1C will be described.

A structure body which is used for a pair of sealing layers that forms a photoelectric conversion device according to one embodiment of the present invention is a structure body in which a fibrous body is impregnated with an organic resin, which can be a strip-shaped structure body capable of being rolled. A photoelectric conversion element group is formed in an upper layer of the rolled structure body, which serves as an element formation substrate, and is sealed with another rolled structure body, whereby photoelectric conversion devices according to one embodiment of the present invention can be manufactured with high productivity.

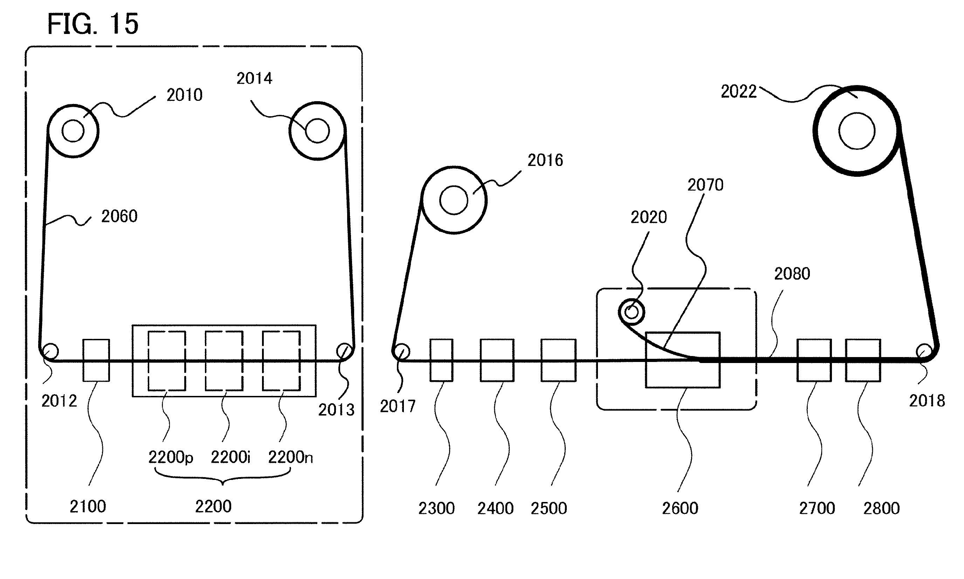

FIG. 15 illustrates an example of a manufacturing process of a photoelectric conversion device by a roll-to-roll method according to this embodiment. A first sealing layer 2060 using the first structure body 160 in which the first fibrous body 162 is impregnated with the first organic resin 164 is transferred from a transfer roll 2010, and a photoelectric conversion element group is formed through each processing means. After that, the photoelectric conversion element group is sealed with a second sealing layer 2070 using the second structure body 170, and a completed photoelectric conversion device 2080 is wound up by a winding roll 2022. As each processing means, various film formation apparatuses such as a sputtering apparatus, a vacuum evaporation apparatus, or a CVD apparatus such as a plasma CVD apparatus; a printing apparatus such as a screen printing apparatus; a processing apparatus such as a laser scribing apparatus; a pressure-bonding apparatus; and the like can be given, and each processing means is independent.

FIG. 15 illustrates an example in which the following are included along a traveling direction in the transfer course: a first treatment chamber 2100 for forming the first electrode 120; a second treatment chamber 2200 for forming the photoelectric conversion layer 130; a third treatment chamber 2300 and a fourth treatment chamber 2400 for performing element isolation of the photoelectric conversion layer 130; a fifth treatment chamber 2500 for forming the second electrodes 140a to 140d; a sixth treatment chamber 2600 for attaching the second sealing layer 2070; a seventh treatment chamber 2700 for forming an opening for forming an output terminal; and an eighth treatment chamber 2800 for forming the output terminal. In addition, in this embodiment, an example in which manufacture by a roll-to-roll method is performed by separating the vacuum process and a rolled base is delivered between the separated processes is shown.

The first sealing layer 2060 using the first structure body 160 is wound by the transfer roll 2010. The first structure body 160 used for the first sealing layer 2060 is cured in advance so that an element can be formed. Note that the first structure body 160 used for the first sealing layer 2060 which is wound by the transfer roll 2010 may be semi-cured and cured after being transferred from the transfer roll 2010.

The first electrode 120 is formed over the first sealing layer 2060 which is transferred to the first treatment chamber 2100. For example, in the first treatment chamber 2100, the first electrode 120 is formed using ITO by a sputtering method.

The first sealing layer 2060 in which the first electrode 120 is formed is transferred to the second treatment chamber 2200 and the photoelectric conversion layer 130 is formed. For example, in the second treatment chamber 2200, a photoelectric conversion layer 130 in which a p-type amorphous semiconductor layer, an i-type amorphous semiconductor layer, and an n-type amorphous semiconductor layer are sequentially stacked over the first electrode 120 by a plasma CVD method is formed. Here, an example in which a first chamber 2200p as a p-type semiconductor layer film formation chamber, a second chamber 2200i as an i-type semiconductor layer film formation chamber, and a third chamber 2200n as an n-type semiconductor layer film formation chamber are provided is shown, and a pin junction semiconductor layer can be formed continuously.

The first sealing layer 2060 on which the first electrode 120 and the photoelectric conversion layer 130 are formed is wound by an intermediate winding roll 2014. The steps up to here are preferably performed under reduced pressure. Therefore, in this embodiment, the first sealing layer 2060 is wound up by the intermediate winding roll 2014 after the photoelectric conversion layer 130 is formed. Note that in order to perform transfer or the like smoothly, it is preferable to provide an auxiliary roll or the like as appropriate. Here, au auxiliary roll 2012 and an auxiliary roll 2013 are provided.

Next, the first sealing layer 2060 which is transferred from an intermediate transfer roll 2016 and on which the first electrode 120 and the photoelectric conversion layer 130 are formed is transferred to the third treatment chamber 2300, and the openings which penetrate the photoelectric conversion layer 130 and the first electrode 120 are formed. For example, in the third treatment chamber 2300, the openings which penetrate the photoelectric conversion layer 130 and the first electrode 120 are formed by a laser scribing method. Here, the following openings are formed: an opening for integrating photoelectric conversion elements by element isolation or connection in series; and an opening for exposing the first structure body 160 used for the first sealing layer 2060 in the peripheral region of a formation portion of the photoelectric conversion element group.

Note that the intermediate transfer roll 2016 which transfers the first sealing layer 2060 is the first sealing layer 2060 on which the first electrode 120 and the photoelectric conversion layer 130 are formed in initial steps and wound up by the intermediate winding roll 2014. Therefore, the intermediate winding roll 2014 which wounds the first sealing layer 2060 on which the first electrode 120 and the photoelectric conversion layer 130 are formed can be set as the intermediate transfer roll 2016 directly or by being separated into a certain length.

The photoelectric conversion layer 130 is separated by openings, and the first sealing layer 2060 in which the first structure body 160 is exposed in the peripheral portion is transferred to the fourth treatment chamber 2400. Accordingly, insulating layers that fill the openings for element isolation are formed. For example, in the fourth treatment chamber 2400, the insulating layers that fill the openings for element isolation are formed by a printing method. Here, the insulating layers are selectively formed in desired openings.

The first sealing layer 2060 in which up to element isolation by the insulating layers is performed is transferred to the fifth treatment chamber 2500, and the second electrodes are formed. For example, in the fifth treatment chamber 2500, the second electrodes are formed by a printing method, whereby photoelectric conversion elements in each of which the first electrode, the photoelectric conversion layer, and the second electrode are sequentially stacked are formed. Here, by selectively filling the desired openings with the conductive material that forms the second electrode and electrically connecting the first electrode and the second electrode of the adjacent photoelectric conversion elements, the photoelectric conversion element group 110 in which the photoelectric conversion elements are connected in series is formed. In addition, an electrode which functions as an extraction electrode is formed in the same step as the second electrodes.

The first sealing layer 2060 in which the photoelectric conversion element group 110 is formed is transferred to the sixth treatment chamber 2600 after various steps, and attached to the second sealing layer 2070. For example, in the sixth treatment chamber 2600, the second sealing layer 2070 using the second structure body 170 which is transferred from a sealing roll 2020 is heated, and the second structure body 170 is cured by being pressure-bonded to the first sealing layer 2060 in which the photoelectric conversion element group 110 is formed. The second organic resin 174 of the second structure body 170 is uniformly spread so as to be in close contact with the photoelectric conversion element group 110 and the exposed first structure body 160 by a heat treatment and a pressure treatment. The curing is performed in such a state, so that the photoelectric conversion element group 110 can be sealed between the first sealing layer 2060 and the second sealing layer 2070. The sixth treatment chamber 2600 is preferably under reduced pressure.

The photoelectric conversion device 2080 in which the photoelectric conversion element group 110 is interposed between the first sealing layer 2060 and the second sealing layer 2070 to be sealed is transferred to the seventh treatment chamber 2700, and the opening for forming the output terminal is formed. For example, in the seventh treatment chamber 2700, an opening that reaches an electrode which functions as an extraction electrode is formed in the second sealing layer 2070.

The photoelectric conversion device 2080 provided with an opening through which an extraction electrode is exposed is transferred to the eighth treatment chamber 2800, and the output terminal 180a and the output terminal 180b are formed. For example, in the eighth treatment chamber 2800, the opening formed in the second sealing layer 2070 is filled, and the output terminal 180a and the output terminal 180b which extract generated power outside are formed.

A strip-shape base in which a plurality of photoelectric conversion devices 2080 are formed in the long-side direction is wound by the winding roll 2022. The strip-shape base may be divided into separate photoelectric conversion devices. Through the above-described process, photoelectric conversion devices can be manufactured with high productivity.

In a photoelectric conversion device according to one embodiment of the present invention, a structure body in which a fibrous body is impregnated with an organic resin is used for a sealing layer. Therefore, the photoelectric conversion device can have high resistance to external stress without any loss of flexibility. Therefore, even in the case where a manufacturing method such as a roll-to-roll method, in which transformation such as curvature is given, incidence of breakage or defective characteristics in the manufacturing process can be prevented. Therefore, highly reliable photoelectric conversion devices can be manufactured with high productivity.

The roll-to-roll method described in this embodiment is just an example, and the embodiment of the present invention is not particularly limited. A method in which a rolled base is delivered between processes may be employed, or all the steps may be performed sequentially. Alternatively, part of the manufacturing process may be performed by a roll-to-roll method. In addition, a low-pressure process, a normal-pressure process, or the like can be determined by practitioners as appropriate.

Note that this embodiment can be combined with any of other embodiments as appropriate.
The present application is based on Japanese Patent Application serial No. 2008-180808 filed with Japan Patent Office on July 10, 2008, the entire contents of which are hereby incorporated by reference.

## Claims

1. A photoelectric conversion device comprising:
a first sealing layer and a second sealing layer provided to face each other; and
a photoelectric conversion element group between the first sealing layer and second sealing layer,
wherein the first sealing layer includes a first structure body in which a first fibrous body is impregnated with a first organic resin,
wherein the second sealing layer includes a second structure body in which a second fibrous body is impregnated with a second organic resin, and
wherein a periphery of the photoelectric conversion element group includes a region where the first sealing layer and second sealing layer are attached to each other.

2. The photoelectric conversion device according to claim 1, wherein the first protective layer and the second protective layer contain any one of an aramid resin, a polyethylene terephthalate resin, a polyethylene naphthalate resin, a polyether sulfone resin, a polyphenylene sulfide resin, and a polyimide resin.

3. The photoelectric conversion device according to claim 1, wherein at least one of the surface of the first sealing layer and the surface of the second sealing layer is provided with a conductive layer.

4. The photoelectric conversion device according to claim 1, wherein an inorganic insulating layer is provided at least one of between the photoelectric conversion element group and the first structure body and between the photoelectric conversion element group and the second structure body.

5. The photoelectric conversion device according to claim 1, wherein the first sealing layer and the second sealing layer have symmetrical layer structures with respect to the photoelectric conversion element group.

6. The photoelectric conversion device according to claim 1, wherein the first organic resin and the second organic resin contain a thermosetting resin or a thermoplastic resin.

7. The photoelectric conversion device according to claim 1, wherein the first fibrous body and the second fibrous body are poly(vinyl alcohol) fiber, polyester fiber, polyamide fiber, polyethylene fiber, aramid fiber, polyparaphenylenebenzobisoxazole fiber, glass fiber, or carbon fiber.

8. The photoelectric conversion device according to claim 1, wherein the photoelectric conversion element group includes a plurality of photoelectric conversion elements which are electrically connected in series.

9. A photoelectric conversion device comprising:
a first sealing layer and a second sealing layer provided to face each other; and
a photoelectric conversion element group between the first sealing layer and second sealing layer,
wherein the first sealing layer includes a first structure body in which a first fibrous body is impregnated with a first organic resin, and a first protective layer having a modulus of elasticity lower than that of the first structure body on a side of the first structure body, which is opposed to a side in contact with the second sealing layer,
wherein the second sealing layer includes a second structure body in which a second fibrous body is impregnated with a second organic resin, and a second protective layer having a modulus of elasticity lower than that of the second structure body on a side of the second structure body, which is opposed to a side in contact with the first sealing layer, and
wherein a periphery of the photoelectric conversion element group includes a region where the first sealing layer and second sealing layer are attached to each other.

10. The photoelectric conversion device according to claim 9, wherein the first protective layer and the second protective layer contain any one of an aramid resin, a polyethylene terephthalate resin, a polyethylene naphthalate resin, a polyether sulfone resin, a polyphenylene sulfide resin, and a polyimide resin.

11. The photoelectric conversion device according to claim 9, wherein at least one of the surface of the first sealing layer and the surface of the second sealing layer is provided with a conductive layer.

12. The photoelectric conversion device according to claim 9, wherein an inorganic insulating layer is provided at least one of between the photoelectric conversion element group and the first structure body and between the photoelectric conversion element group and the second structure body.

13. The photoelectric conversion device according to claim 9, wherein the first sealing layer and the second sealing layer have symmetrical layer structures with respect to the photoelectric conversion element group.

14. The photoelectric conversion device according to claim 9, wherein the first organic resin and the second organic resin contain a thermosetting resin or a thermoplastic resin.

15. The photoelectric conversion device according to claim 9, wherein the first fibrous body and the second fibrous body are poly(vinyl alcohol) fiber, polyester fiber, polyamide fiber, polyethylene fiber, aramid fiber, polyparaphenylenebenzobisoxazole fiber, glass fiber, or carbon fiber.

16. The photoelectric conversion device according to claim 9, wherein the photoelectric conversion element group includes a plurality of photoelectric conversion elements which are electrically connected in series.
